# EUROPEAN PATENT APPLICATION

(11) **EP 2 253 650 A1**
(43) Date of publication of application: **24.11.2010**
(21) Application number: 10004457.7
(22) Date of filing: 27.04.2010
(51) Int. Cl.: C08G 18/08, C08G 61/12, C08J 3/00, C08L 65/00, H01L 51/00, C08G 18/12, C08G 18/38, C08G 18/66

(54) **Electrically conductive films formed from dispersions comprising conductive polymers and polyurethanes**

(30) Priority: 27.04.2009 US 430368
(71) Applicant: Air Products and Chemicals, Inc., Allentown, PA 18195-1501 (US)
(72) Inventor: Fazel, Shafiq Nisarali, 18104 Allentwon (US); Zheng, Shiying, 18034 Center Valley (US)
(74) Representative: Kador & Partner

(57) **Abstract**

An aqueous dispersion and a method for making an aqueous dispersion. The dispersion including at least one conductive polymer such as a polythienothiophene, at least one polyurethane polymer and optionally at least one colloid-forming polymeric acid and one non-fluorinated polymeric acid. Devices utilizing layers formed of the inventive dispersions are also disclosed.

## Description

### FIELD OF THE INVENTION

The present disclosure relates to producing electrically conductive films cast from aqueous dispersions comprising electrically conducting polymers. In particular, the present disclosure is directed to conductive polymer dispersions synthesized in the presence of at least one polyurethane polymer.

### BACKGROUND OF THE INVENTION

Electrically conducting polymers have been used in a variety of organic electronic devices, including in the development of electroluminescent (EL) devices for use in light emissive displays. With respect to EL devices, such as organic light emitting diodes (OLEDs) containing conducting polymers, such devices generally have the following configuration:
anode/hole injection layer/EL layer/cathode

The anode is typically any material that has the ability to inject holes into the otherwise filled π-band of the semiconducting material used in the EL layer, such as, for example, indium/tin oxide (ITO). The anode is optionally supported on a glass or plastic substrate. The EL layer is typically semiconducting, conjugated organic material, including a conjugated semiconducting polymer such as poly(paraphenylenevinylene), polyfluorene, spiropolyfluorene or other EL polymer material, a small molecule fluorescent dye such as 8-hydroxquinoline aluminum (Alq₃), a small molecule phosphorescent dye such as fac tris(2-phenylpyridine) iridium (III) (doped in a host matrix), a dendrimer, a conjugated polymer grafted with phosphorescent dye, a blend that contains the above-mentioned materials, and combinations. The EL layer can also be inorganic quantum dots or blends of semiconducting organic material with inorganic quantum dots. The cathode is typically any material (such as, e.g., Ca or Ba) that has the ability to inject electrons into the otherwise empty π*-band of the semiconducting organic material in the EL layer.

The hole injection layer (HIL) is typically a conducting polymer and facilitates the injection of holes from the anode into the semiconducting organic material in the EL layer. The hole injection layer can also be called a hole transport layer, hole injection/transport layer, or anode buffer layer, or may be characterized as part of a bilayer anode. Typical conducting polymers employed as hole injection layer include polyaniline and polydioxythiophenes such as poly(3,4-ethylenedioxythiophene) (PEDOT). These materials can be prepared by polymerizing aniline or dioxythiophene monomers in aqueous solution in the presence of a water soluble polymeric acid, such as poly(styrenesulfonic acid) (PSSA), as described in, for example, U.S. Pat. No. 5,300,575 entitled "Polythiophene dispersions, their production and their use"; hereby incorporated by reference in its entirety. A well known PEDOT/PSSA material is Baytron^{®}-P, commercially available from H. C. Starck, GmbH (Leverkusen, Germany).

Electrically conducting polymers have also been used in photovoltaic devices, which convert radiation energy into electrical energy. Such devices generally have the following configuration:
positive electrode/hole extraction layer/light harvesting layer(s)/negative electrode

The positive electrode and negative electrode can be selected from materials used for the anode and cathode of EL devices mentioned above. The hole extraction layer is typically a conducting polymer that facilitates the extraction of holes from the light harvesting layers for collection at the positive electrode. The light harvesting layer or layers typically consists of organic or inorganic semiconductors that can absorb light radiation and generate separated charges at an interface.

Aqueous electrically conductive polymer dispersions synthesized with water soluble polymeric sulfonic acids have undesirable low pH levels. The low pH can contribute to decreased stress life of an EL device containing such a hole injection layer, and contribute to corrosion within the device. Accordingly, there is a need in this art for compositions and hole injection layer prepared therefrom having improved properties.

Electrically conducting polymers also have utility as electrodes for electronic devices, such as thin film field effect transistors. In such transistors, an organic semiconducting film is present between source and drain electrodes. To be useful for the electrode application, the conducting polymers and the liquids for dispersing or dissolving the conducting polymers have to be compatible with the semiconducting polymers and the solvents for the semiconducting polymers to avoid re-dissolution of either conducting polymers or semiconducting polymers. The electrical conductivity of the electrodes fabricated from the conducting polymers should be greater than 10 S/cm (where S is a reciprocal ohm). However, the electrically conducting polythiophenes made with a polymeric acid typically provide conductivity in the range of about 10⁻³ S/cm or lower. In order to enhance conductivity, conductive additives may be added to the polymer. However, the presence of such additives can deleteriously affect the processability of the electrically conducting polythiophene. Accordingly, there is a need in this art for improved conducting polymers with good processability and increased conductivity.

Therefore what is needed is a process for fabrication of electrically conductive polymers and electrically conductive polymers produced having improved dispersability.

### BRIEF SUMMARY OF THE INVENTION

The present disclosure addresses problems associated with conventional dispersions by providing aqueous dispersions comprising at least one conductive polymer such as polyaniline, polypyrroles, polyselenophenes, polythiophene (e.g., poly(thieno[3,4-b]thiophene) (PTT), PEDOT, and mixtures thereof, among others) and their derivatives or combinations thereof, at least one polyurethane polymer and optionally at least one colloid-forming fluorinated polymeric acid. Relatively small additions of at least one polyurethane polymer to the dispersion may provide improved properties of films cast from the resultant dispersion comprising at least one conductive polymer. The inventive compositions are useful as a hole injection layer in a variety of organic electronic devices, such as, for example, organic light emitting diodes (OLEDs), as hole extraction layer in a variety of organic optoelectronic devices, such as, for example, organic photovoltaic devices (OPVDs), and as the charge injection layer between the source/drain electrodes and the semiconductive channel material, among other applications.

In accordance with one embodiment, the present disclosure relates to organic electronic devices, including electroluminescent devices, comprising a hole injection layer of the inventive compositions. The layers formed with a conductive polymer dispersion according to embodiments of the present disclosure include resistivity stability during annealing process. In accordance with another embodiment, the present disclosure relates to a method for synthesizing aqueous dispersions comprising, and at least one polyurethane polymer and optionally at least one fluorinated colloid-forming polymeric acid. The method for producing an aqueous dispersion comprising at least one conductive polymer, and at least one polyurethane polymer , comprises the following:
(a) providing an aqueous solution comprising at least one oxidant and/or at least one catalyst;
(b) providing an aqueous dispersion comprising an effective amount of the polyurethane polymer;
(c) combining the aqueous solution of the oxidant and/or catalyst with the aqueous dispersion of the polyurethane polymer ;
(d) adding a monomer or a precursor of the conductive polymer to the combined aqueous dispersion of step (c) ;
(e) polymerizating the monomer or precursor containing polyurethane dispersion to form a polymeric dispersion;
(f) contacting the polymeric dispersions with ion exchange resin(s) to remove impurities; and
(g) optionally, adjusting the pH of the polymer dispersion to a pH sufficiently high to provide even more desirable properties.

Alternatively, the method for producing an aqueous dispersion comprising at least one conductive polymer, and at least one polyurethane polymer, comprises the following:
(a) providing an aqueous solution comprising at least one oxidant and/or at least one catalyst;
(b) providing an aqueous dispersion comprising an appropriate amount of the polyurethane polymer;
(c) adding the aqueous dispersion of polyurethane polymer of step (b) to a monomer or a precursor of the conductive polymer;
(d) adding the oxidant and/or catalyst solution of step (a) to the combined mixture of step (c);
(e) polymerizating the monomer or precursor containing polyurethane dispersion to form a condutive polymeric dispersion;
(f) contacting the polymeric dispersions with ion exchange resin(s) to remove impurities; and
(g) optionally, adjusting the pH of the polymer dispersion to a pH sufficiently high to provide even more desirable properties.

In a further embodiment, a film forming additive such as organic solvent, or surfactant can be added to the dispersions to improve coating or printing properties of the conductive polymer dispersions. In another embodiment, counter ions such as Na+, K+, NH₄+ can be added to the dispersion to modify the dispersion and film properties such as pH level, ion content, doping level, work functions, etc. The counter ions can be added by neutralizing the dispersion with a hydroxide base or treatment with ion exchange resin containing Na+, K+, or NH₄+ as counter ion.

In another embodiment, additives such as ionic compounds can be added to the dispersion, for example, in order to modify the dispersion and film properties such as pH level, ion content, doping level, work functions, among other benefits. Examples of suitable sources can comprise at least one member selected from the group consisting guanidine sulfate, ammonium sulfate, and sodium sulfate.

The dispersions according to embodiments of the disclosure can be applied onto any suitable substrate, and dried. If desired, the coated substrate can be heated under conditions sufficient to impart a desired conductivity, device performance and lifetime performance.

### BRIEF DESCRIPTION OF SEVERAL VIEWS OF THE DRAWINGS

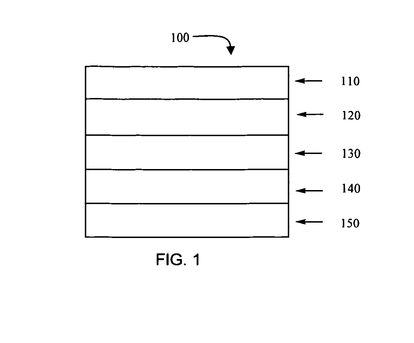

FIG. 1 illustrates an elevational cross-sectional view of an electronic device that includes a hole injection layer according to an embodiment of the present disclosure.

### DETAILED DESCRIPTION OF THE INVENTION

The present disclosure relates to aqueous dispersions, methods for making and applying such dispersions, and devices incorporating containing films obtained from such dispersions. The dispersions according to certain embodiments may comprise at least one conductive polymer such as polyaniline, polypyrroles or polythiophene and/or their derivatives or combinations thereof, at least one polyurethane polymer, and optionally at least one colloid-forming polymeric acids (e.g., at least partially fluorinated ion exchange polymers). As used herein, the term "dispersion" refers to a liquid medium comprising a suspension of minute colloid particles. In accordance with the disclosure, the "liquid medium" is typically an aqueous liquid, e.g., de-ionized water. As used herein, the term "aqueous" refers to a liquid that has a significant portion of water and in one embodiment it is at least about 40% by weight water, optionally, suitable solutes that can be used to effectuate desired properties in a solution and/or dispersion of the exemplary conductive polyurethane containing dispersion. Without wishing to be bound by any theory or explanation, it is believed that the polyurethane polymer can function as a dispersant. Suitable solutes are described below and can include, as non-limiting examples, salts, surfactants, dispersing agents, stabilizing agents, rheology modifiers, and other additives known in the art.

As used herein, the term "polyurethane polymer" means a polymer comprising at least one sulfonic acid, phosphonic acid, boronic acid, or carboxylic acid, either in the acid form or in the neutralized form.

As used herein, the term "urethane" refers to a compound containing one or more urethane and/or urea groups. Non-limiting examples of urethanes that can be used in the disclosure include compounds that contain one or more urethane groups and optionally contain urea groups as well as compounds contain both urethane and urea groups.

As used herein, the term "colloid" refers to the minute particles suspended in the liquid medium, said particles having a particle size up to about 1 micron (e.g., about 20 nanometers to about 800 nanometers and normally about 30 to about 500 nanometers).

As used herein, the term "colloid-forming" refers to substances that form minute particles when dispersed in aqueous solution, i.e., "colloid-forming" polymeric acids are not water-soluble.

As used herein, the terms "comprises", "comprising", "includes", "including", "has", "having" or any other variation thereof, are intended to cover a non-exclusive inclusion. For example, a process, method, article, or apparatus that comprises a list of elements is not necessarily limited to only those elements but may include other elements not expressly listed or inherent to such process, method, article, or apparatus. Further, unless expressly stated to the contrary, "or" refers to an inclusive or and not to an exclusive or. For example, a condition A or B is satisfied by any one of the following: A is true (or present) and B is false (or not present), A is false (or not present) and B is true (or present), and both A and B are true (or present).

Also, use of the "a" or "an" are employed to describe elements and components of the invention. This is done merely for convenience and to give a general sense of the invention. This description should be read to include one or at least one and the singular also includes the plural unless it is obvious that it is meant otherwise.

Conductive polymers that can be employed in the instant disclosure can comprise at least one member selected from the group consisting of polyanilines, polythiophenes, polypyrroles, polyacetylenes, polythienothiophene/polystyrenesulfonic acid, polydioxythiophene/polystyrenesulfonic acid, polyaniline-polymeric-acid-colloids, PEDOT, PEDOT-polymeric-acid-colloids and combinations thereof. Conductive polymers can also include selenium containing polymers such as those disclosed in Application Nos. 11/777,386 filed on July 13,2007 and 11/777,362, filed on July 13, 2007; both hereby incorporated by reference in their entirety.

The electrically conductive polymer may include polymerized units of heterocyclic fused ring monomer units. The conductive polymer can be a polyaniline, polypyrroles or polythiophene and their derivatives or combinations thereof.

Polypyrroles contemplated for use in exemplary compositions have Formula I 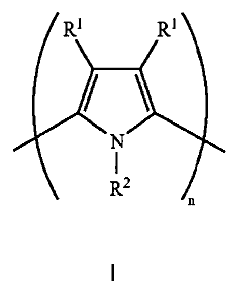 where in Formula I, n is at least about 4; R¹ is independently selected so as to be the same or different at each occurrence and is selected from hydrogen, alkyl, alkenyl, alkoxy, alkanoyl, alkythio, aryloxy, alkylthioalkyl, alkylaryl, arylalkyl, amino, alkylamino, dialkylamino, aryl, alkylsulfinyl, alkoxyalkyl, alkylsulfonyl, arylthio, arylsulfinyl, alkoxycarbonyl, arylsulfonyl, acrylic acid, phosphoric acid, phosphonic acid, halogen, nitro, cyano, hydroxyl, epoxy, silane, siloxane, alcohol, amidosulfonate, benzyl, carboxylate, ether, ether carboxylate, ether sulfonate, and urethane; or both R¹ groups together may form an alkylene or alkenylene chain completing a 3, 4, 5, 6, or 7-membered aromatic or alicyclic ring, which ring may optionally include one or more divalent nitrogen, sulfur or oxygen atoms; and R² is independently selected so as to be the same or different at each occurrence and is selected from hydrogen, alkyl, alkenyl, aryl, alkanoyl, alkylthioalkyl, alkylaryl, arylalkyl, amino, epoxy, silane, siloxane, alcohol, amidosulfonate, benzyl, carboxylate, ether, ether carboxylate, ether sulfonate, sulfonate, and urethane.

In one embodiment, R¹ is the same or different at each occurrence and is independently selected from hydrogen, alkyl, alkenyl, alkoxy, cycloalkyl, cycloalkenyl, alcohol, amidosulfonate, benzyl, carboxylate, ether, ether carboxylate, ether sulfonate, sulfonate, urethane, epoxy, silane, siloxane, and alkyl substituted with one or more of sulfonic acid, carboxylic acid, acrylic acid, phosphoric acid, phosphonic acid, halogen, nitro, cyano, hydroxyl, epoxy, silane, or siloxane moieties.

In one embodiment, R² is selected from hydrogen, alkyl, and alkyl substituted with one or more of sulfonic acid, carboxylic acid, acrylic acid, phosphoric acid, phosphonic acid, halogen, cyano, hydroxyl, epoxy, silane, or siloxane moieties.

In one embodiment, the polypyrrole is unsubstituted and both R¹ and R² are hydrogen.

In one embodiment, both R¹ together form a 6-or 7-membered alicyclic ring, which is further substituted with a group selected from alkyl, heteroalkyl, alcohol, amidosulfonate, benzyl, carboxylate, ether, ether carboxylate, ether sulfonate, sulfonate, and urethane. These groups can improve the solubility of the monomer and the resulting polymer. In one embodiment, both R¹ together form a 6-or 7-membered alicyclic ring, which is further substituted with an alkyl group. In one embodiment, both R¹ together form a 6-or 7-membered alicyclic ring, which is further substituted with an alkyl group having at least 1 carbon atom.

In one embodiment, both R¹ together form--O--(CHY)ₘ--O--, where m is 2 or 3, and Y is the same or different at each occurrence and is selected from hydrogen, alkyl, alcohol, amidosulfonate, benzyl, carboxylate, ether, ether carboxylate, ether sulfonate, sulfonate, and urethane. In one embodiment, at least one Y group is not hydrogen. In one embodiment, at least one Y group is a substituent having F substituted for at least one hydrogen. In one embodiment, at least one Y group is perfluorinated.

In one embodiment, the polypyrrole used in the new composition is a positively charged conductive polymer where the positive charges are balanced by the colloidal polymeric acid anions.

Polythiophenes contemplated for use in the new composition have Formula II below: 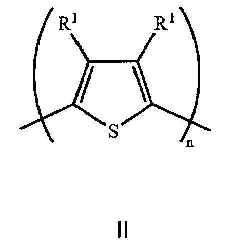 wherein: R¹ is independently selected so as to be the same or different at each occurrence and is selected from hydrogen, alkyl, alkenyl, alkoxy, alkanoyl, alkythio, aryloxy, alkylthioalkyl, alkylaryl, arylalkyl, amino, alkylamino, dialkylamino, aryl, alkylsulfinyl, alkoxyalkyl, alkylsulfonyl, arylthio, arylsulfinyl, alkoxycarbonyl, arylsulfonyl, acrylic acid, phosphoric acid, phosphonic acid, halogen, nitro, cyano, hydroxyl, epoxy, silane, siloxane, alcohol, amidosulfonate, benzyl, carboxylate, ether, ether carboxylate, ether sulfonate, and urethane; or both R¹ groups together may form an alkylene or alkenylene chain completing a 3, 4, 5, 6, or 7-membered aromatic or alicyclic ring, which ring may optionally include one or more divalent nitrogen, sulfur or oxygen atoms, and n is at least about 4.

In one embodiment, both R¹ together form--O--(CHY)ₘ-O--, where m is 2 or 3, and Y is the same or different at each occurrence and is selected from hydrogen, alkyl, alcohol, amidosulfonate, benzyl, carboxylate, ether, ether carboxylate, ether sulfonate, and urethane. In one embodiment, all Y are hydrogen. In one embodiment, the polythiophene is poly(3,4-ethylenedioxythiophene) (PEDOT). In one embodiment, at least one Y group is not hydrogen. In one embodiment, at least one Y group is a substituent having F substituted for at least one hydrogen. In one embodiment, at least one Y group is perfluorinated.

In one embodiment, the polythiophene is a poly[(sulfonic acid-propylene-ether-methylene-3,4-dioxyethylene)thiophene]. In one embodiment, the polythiophene is a poly[(propyl-ether-ethylene-3,4-dioxyethylene)thiophene].

In one embodiment, the disclosure provides monomeric, oligomeric and polymeric compositions having repeating unit having formula III, as follows: 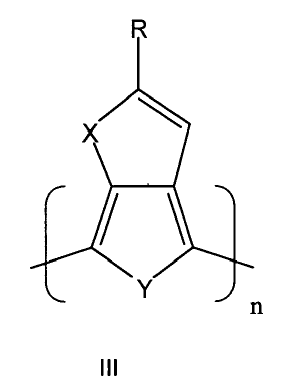 wherein X is S or Se, Y is S or Se , R is a substituent group. n is greater than about 2 and less than 20 and normally about 4 to about 16. R may be any substituent group capable of bonding to the ring structure of III. R may include hydrogen or isotopes thereof, hydroxyl, alkyl, including C₁ to C₂₀ primary, secondary or tertiary alkyl groups, arylalkyl, alkenyl, perfluoroalkyl, perfluororaryl, aryl, alkoxy, cycloalkyl, cycloalkenyl, alkanoyl, alkylthio, aryloxy, alkylthioalkyl, alkynyl, alkylaryl, arylalkyl, amido, alkylsulfinyl, alkoxyalkyl, alkylsulfonyl, aryl, arylamino, diarylamino, alkylamino, dialkylamino, arylarylamino, arylthio, heteroaryl, arylsulfinyl, alkoxycarbonyl, arylsulfonyl, carboxyl, halogen, nitro, cyano, sulfonic acid, or alkyl or phenyl substituted with one or more sulfonic acid (or derivatives thereof), phosphoric acid (or derivatives thereof), carboxylic acid (or derivatives thereof), halo, amino, nitro, hydroxyl, cyano or epoxy moieties. In certain embodiments R may include alpha reactive sites, wherein branched oligomeric, polymeric or copolymeric structures of the selenium containing ring structure may be formed. In certain embodiments, R may include hydrogen, alkylaryl, arylalkyl, aryl, heteroaryl, C₁ to C₁₂ primary, secondary or tertiary alkyl groups, which may be mono- or polysubstituted by F, Cl, Br, I or CN, and wherein one or more non-adjacent CH₂ groups may be replaced, independently with -O-, -S-, -NH-, -NR'-, -SiR'R"-, -CO-, -COO-, -OCO-, -OCO-O-, -S- CO-, -CO-S-, -CH=CH- or -C=C- in such a manner that O and/or S atoms are not linked directly to one another, phenyl and substituted phenyl groups, cyclohexyl, naphthalenic, hydroxyl, alkyl ether, perfluoroalkyl, perfluoroaryl, carboxylic acids, esters and sulfonic acid groups, perfluoro, SF₅, or F. R and R" are independently of each other H, aryl or alkyl with 1 to 12 C-atoms. The polymer can include end-groups independently selected from functional or non-functional end-groups. The repeating structures according to the present disclosure may be substantially identical, forming a homopolymer, or may be copolymeric nature by selecting monomers suitable for copolymerization. The repeating unit may be terminated in any suitable manner known in the art and may include functional or non-functional end groups. In one embodiment, the composition includes an aqueous dispersion of a polymeric acid doped polymer according to III.

In one aspect of the disclosure, aqueous dispersions comprising electrically conductive polythienothiophenes such as poly(thieno[3,4-b]thiophene) can be prepared when thienothiophene monomers including thieno[3,4-b]thiophene monomers are polymerized chemically in the presence of at least one partially fluorinated polymeric acid

Compositions according to one embodimentcomprise a continuous aqueous phase in which the poly(thieno[3,4-b]thiophene) and dispersion-forming partially fluorinated polymeric acid are dispersed. Poly(thieno[3,4-b]thiophenes) that can be used in the present disclosure can have the structure (IV) and (V): 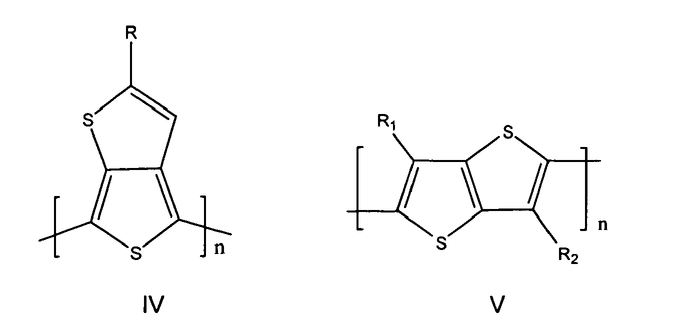 wherein R is selected from hydrogen, an alkyl having 1 to 8 carbon atoms, phenyl, substituted phenyl, CₘF₂ₘ₊₁, F, Cl, and SF₅, and n is greater than about 2 and less than 20 and normally about 4 to about 16.

Thienothiophenes that can be used in the compositions of this disclosure may also have the structure (V) as provided above, wherein R₁ and R₂ are independently selected from the list above. In one particular embodiment, the polythienothiophene comprises poly(thieno[3,4-b]thiophene) wherein R comprises hydrogen.

Another aspect of the disclosure includes the conductive polymer poly(selenolo[2,3-c]thiophene). The polymers for use with this disclosure may include copolymers further comprising polymerized units of an electroactive monomer. Electroactive monomers may be selected from the group consisting of thiophenes, thieno[3,4-b]thiophene, thieno[3,2-b]thiophene, substituted thiophenes, substituted thieno[3,4-b]thiophenes, substituted thieno[3,2-b]thiophene, dithieno[3,4-b:3',4'-d]thiophene, selenophenes, substituted selenophenes, pyrrole, bithiophene, substituted pyrroles, phenylene, substituted phenylenes, naphthalene, substituted naphthalenes, biphenyl and terphenyl, substituted terphenyl, phenylene vinylene, substituted phenylene vinylene, fluorene, substituted fluorenes. In addition to electroactive monomers, the copolymers according to the present disclosure may include polymerized units of a non-electroactive monomers.

Polyaniline compounds which can be used in the present disclosure can be obtained from aniline monomers having Formula VI below: 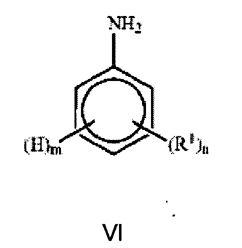 wherein n is an integer from 0 to 4; m is an integer from 1 to 5, with the proviso that n+m=5; and R¹ is independently selected so as to be the same or different at each occurrence and is selected from alkyl, alkenyl, alkoxy, cycloalkyl, cycloalkenyl, alkanoyl, alkythio, aryloxy, alkylthioalkyl, alkylaryl, arylalkyl, amino, alkylamino, dialkylamino, aryl, alkylsulfinyl, alkoxyalkyl, alkylsulfonyl, arylthio, arylsulfinyl, alkoxycarbonyl, arylsulfonyl, carboxylic acid, halogen, cyano, or alkyl substituted with one or more of sulfonic acid, carboxylic acid, halo, nitro, cyano or epoxy moieties; or any two R¹ groups together may form an alkylene or alkenylene chain completing a 3, 4, 5, 6, or 7-membered aromatic or alicyclic ring, which ring may optionally include one or more divalent nitrogen, sulfur or oxygen atoms.

The polymerized material comprises aniline monomer units, each of the aniline monomer units having a formula selected from Formula VII below: 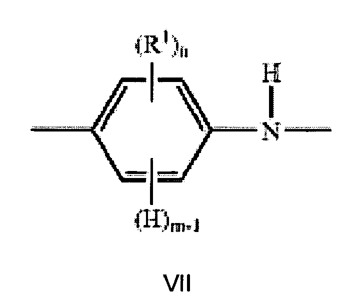 or Formula VIII below: 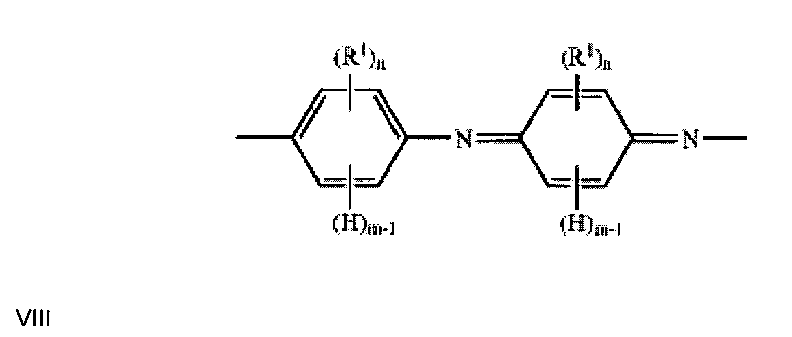 wherein n, m, and R¹ are as defined above. In addition, the polyaniline may be a homopolymer or a co-polymer of two or more aniline monomeric units.

The compositions of the present disclosure are not limited to the homopolymeric structures above and may include hetereopolymeric or copolymeric structures. The copolymeric structures may be any combination of alternating copolymers(e.g., alternating A and B units), periodic copolymers (e.g., (A-B-A-B-B-A-A-A-A-B-B-B)n, random copolymers (e.g., random sequences of monomer A and B), statistical copolymers (e.g., polymer sequence obeying statistical rules) and/or block copolymers (e.g., two or more homopolymer subunits linked by covalent bonds). The copolymers may be branched or linked, provided the resultant copolymer maintains the properties of electrical conductivity.

The polyurethane polymer of the present disclosure comprises at least one radical of an aromatic or a heteroaromatic or an aliphatic compound, wherein the polymer includes at least one sulfonic acid, phosphonic acid, boronic acid, or carboxylic acid, either in the acid form or in the neutralized form.

The polyurethane polymers of the present display a number of advantages. These include: improved thermal stability, excellent film forming property, reduced water uptake, defined adjustable functional groups for the most different technical applications.

The present disclosure is also directed to an aqueous polyurethane dispersion that includes an aqueous medium and a polyurethane that contains at least one sulfonic acid, phosphonic acid, boronic acid, or carboxylic acid, either in the acid form or in the neutralized form. In some cases, the sulfonic acid, phosphonic acid, boronic acid, or carboxylic acid, either in the acid form or in the neutralized form is as pendent side chain to the polyurethane.

The production of linear or cross-linked aqueous polyurethane dispersions is well known as disclosed in U.S. Pat. No. 4,108,814; which describe linear polyurethane and U.S. Pat. No. 3,870,684, which describe cross-linked polyurethane, which are hereby incorporated by reference in their entirety. The aqueous polyurethane dispersions may be used for a wide range of commercial applications such as adhesives or coatings for various substrates including textile fabrics, plastic, wood, glass fibers and metals. Chemical resistance, water resistance, abrasion resistance, toughness, tensile strength, elasticity and durability are among the many desirable properties of these coatings and films. The polyurethane polymer of the present disclosure comprises at least one sulfonic acid, phosphonic acid, boronic acid, or carboxylic acid, either in the acid form or in the neutralized form. Optionally the polyurethane may include O, S, N, B, P, Si, or halogen atoms. More specifically, the polyurethane polymer of the present disclosure comprises at least one pendent side chain selected from the general formula (1A) - (1 D), wherein the R₁ independently of one another, and is a direct bond, or selected from a group having from 1 to 60 carbon atoms, and optionally include O, N, S, B, P, Si, or halogen atoms. For xample, a branched or unbranched alkyl or cycloalkyl group or substituted alkyl or substituted cycloalkyl or an aryl group or a hetero aryl group. R₁ can be optionally substituted with silicon atom, halogen atoms, nitro group, amino group, cyano group. For example, R₁ can be substituted with halogen atoms such as chlorine or fluorine atom. X is independently of one another, and is hydrogen, a one- or multivalent cation, such as at least one member from the group of Li⁺, Na⁺, K⁺, Rb⁺, Cs⁺, TiO²⁺, ZrO²⁺, Ti⁴⁺, Zr⁴⁺, Ca²⁺, Mg²⁺ or an ammonium ion.

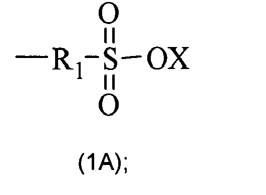

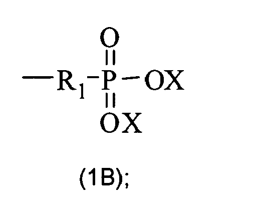

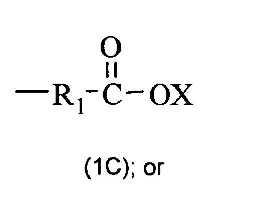

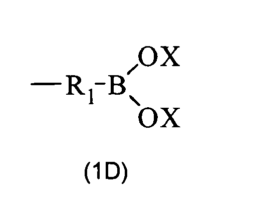

The polyurethane polymer of the present disclosure comprises at least 5 mol% of repeat units incorporating pendent side chain of general formulas (1A)-(1D) based on the total repeat units of the polyurethane, in some cases at least 10 mol%, another cases at least 15 mol%, and in some situations at least 20 mol%.

As used herein the term "alkyl" refers to a monovalent radical of an aliphatic hydrocarbon chain of general formula CₛH₂ₛ₊₁, where s is the number of carbon atoms, or ranges therefore, as specified. The term "substituted alkyl" refers to an alkyl group, where one or more hydrogens are replaced with a non-carbon atom or group, non-limiting examples of such atoms or groups include halides, amines, alcohols, oxygen (such as ketone or aldehyde groups), and thiols.

As used herein the term "cycloalkyl" refers to a monovalent radical of an aliphatic hydrocarbon chain that forms:a ring of general formula CₛH₂ₛ₋₁, where s is the number of carbon atoms, or ranges therefore, as specified. The term "substituted cycloalkyl" refers to a cycloalkyl group, containing one or more hetero atoms, non-limiting examples being- -O--,--NR'--, and--S--in the ring structure, and/or where one or more hydrogens are replaced with a non-carbon atom or group, non-limiting examples of such atoms or groups include halides, amines, alcohols, oxygen (such as ketone or aldehyde groups), and thiols. R' represents an alkyl group of from 1 to 24 carbon atoms.

As used herein, the term "aryl" refers to a monovalent radical of an aromatic hydrocarbon. Aromatic hydrocarbons include those carbon based cyclic compounds containing conjugated double bonds where 4t+2 electrons are included in the resulting cyclic conjugated pi-orbital system, where t is an integer of at least 1. As used herein, aryl groups can include single aromatic ring structures, one or more fused aromatic ring structures, covalently connected aromatic ring structures, any or all of which can include heteroatoms. Non-limiting examples of such heteroatoms that can be included in aromatic ring structures include O, N, and S.

The polyurethane polymer of the present disclosure comprises at least one pendent side chain of the general formulas (1A)-(1D), and optionally hydrophilic moieties. As used herein the terms "hydrophilic moieties" and "hydrophilic groups" refer to substituent and/or pendent groups on a polyurethane that improve the compatibility, dispersibility, and/or solubility of the polyurethane with and/or in water and/or an aqueous medium. Non-limiting examples of hydrophilic moieties and/or groups that can be used in the present disclosure are described below and include polyether groups, which typically include repeat units derived from ethylene oxide, and/or ionic groups, i.e., anionic or cationic groups. The polyurethane polymer of the present disclosure may be water soluble or water dispersible.

In a particular embodiment of the disclosure, the hydrophilic moieties in the polyurethane polymer include one or more groups selected from lateral and terminal chains containing alkylene oxide units, cationic groups and anionic groups. Further to this embodiment, non-limiting examples of the alkylene oxide units can be repeat units derived from ethylene oxide, non-limiting examples of cationic groups can include amine groups neutralized with an acid, and non-limiting examples of anionic groups can include carboxylate groups, phosphate groups, and sulfonated groups neutralized with a tertiary amine, sodium, potassium, and/or lithium ion.

In an embodiment of the disclosure, the polyurethane that includes at least one pendent side chain of the general formulas (1A)-(1D)is prepared by reacting a suitable compound that contains at least one suitable isocyanate reactive group and at least one pendent side chain of the general formulas (1A)-(1D) with a compound that contains at least one isocyanate group. Suitable isocyanate reactive groups include, but are not limited to--OH,--NH₂,--NHR₂, and--SH, where R₂ is independently selected from H, C₁-C₆ alkyl, substituted C₁-C₆ alkyl, cycloalkyl, aryl and heteroaryl.

Further to this embodiment, the suitable compound containing isocyanate reactive groups can be a reaction product. As a non-limiting example, the reaction product containing isocyanate reactive groups can be prepared by reacting a mixture of polyols, in some cases diols, and optionally monools, providing an excess of hydroxyl groups with diisocyanates and optionally monoisocyanates to form a hydroxyl-containing reaction product containing --OH prepolymers and monools formed by the reaction of one mole of a diol with one mole of the optional monoisocyanate. In a particular embodiment, the diols and monools are polyethers.

Suitable diisocyanates which may be used to prepare the polyurethane are known and include, but are not limited to, organic diisocyanates represented by the formula, R₁₀(NCO)₂. Suitable monoisocyanates are represented by the formula HR₁₀NCO. In each instance, R₁₀ independently represents an organic group obtained by removing the isocyanate groups from an organic diisocyanate having a molecular weight of from about 56 to 1,000 in some cases from about 82 to 400.

In an embodiment of the disclosure, the diisocyanates are those represented by the above formula in which R₁₀ represents a divalent aliphatic hydrocarbon group having from 4 to 18 carbon atoms, a divalent cycloaliphatic hydrocarbon group having from 5 to 15 carbon atoms, a divalent araliphatic hydrocarbon group having from 7 to 15 carbon atoms or a divalent aromatic hydrocarbon group having 6 to 15 carbon atoms.

Further to this embodiment, the suitable organic diisocyanates can include 1,4-tetramethylene diisocyanate, 1,6-hexamethylene diisocyanate (HDI), 2,2,4-trimethyl-1,6-hexamethylene diisocyanate, 1,12-dodecamethylene diisocyanate, cyclohexane-1,3-and-1,4-diisocyanate, 1-isocyanato-2-isocyanatomethyl cyclopentane, 1-isocyanato-3-isocyanatomethyl-3,5,5-trimethyl-cyclohexane (isophorone diisocyanate or IPDI), bis-(4-isocyanato-cyclohexyl)-methane, 1,3-and 1,4-bis-(isocyanatomethyl)-cyclohexane, bis-(4-isocyanatocyclohexyl)-methane, 2,4'-diisocyanato-dicyclohexyl methane, bis-(4-isocyanato-3-methyl-cyclohexyl)-methane, α, α, α,α-tetramethyl-1,3-and/or-1,4-xylylene diisocyanate (TMXDI), 1-isocyanato-1-methyl-4(3) cyclohexane, 2,4-and/or 2,6-hexahydro-toluylene diisocyanate, 1,3-and/or 1,4-phenylene diisocyanate, 2,4-and/or 2,6-toluylene diisocyanate, 2,4-and/or 4,4'-diphenylmethane diisocyanate and 1,5-diisocyanato naphthalene and mixtures thereof.

In some embodiments, small amounts, such as amounts up to 5%, or from 0.1 % to 5%, or from 0.5% to 3.5% based on the weight of total isocyanate containing compounds, of optional polyisocyanates containing 3 or more isocyanate groups can be used. Non-limiting examples of suitable polyisocyanates that can be used include 4-isocyanatomethyl-1 ,8-octamethylene diisocyanate and aromatic polyisocyanates such as 4,4',4"-triphenylmethane triisocyanate and polyphenyl polymethylene polyisocyanates obtained by phosgenating aniline/formaldehyde condensates.

In a particular embodiment, the diisocyanates include bis-(4-isocyanatocyclohexyl)-methane, α, α, α,α-tetramethyl-1,3-and/or-1,4-xylylene diisocyanate (TMXDI), 1 ,6-hexamethylene diisocyanate (HDI) and isophorone diisocyanate (IPDI), especially 1,6-hexamethylene diisocyanate (HDI) and isophorone diisocyanate (IPDI).

Embodiments of the disclosure provide that the polyols are one or a mixture of polyester polyols, polyether polyols, polyhydroxy polycarbonates, polyhydroxy polyacetals, polyhydroxy polyacrylates, polyhydroxy polyester amides and polyhydroxy polythioethers, and polysiloxane polyols. Particular embodiments provide that the polyols are one or more of polysiloxane polyols, and polyether polyols.

Certain embodiments will use diols as the polyols, however, other embodiments of the disclosure will optionally include polyols that contain three or more hydroxyl groups as part of the mixture of polyols. When polyols that contain three or more hydroxyl groups are used, they are included in the mixture of polyols at a level of up to 10%, or from 0.1 % to 10%, or from 1% to 7.5% based on the total hydroxyl equivalents in the mixture of polyols.

Non-limiting examples of suitable polyester polyols include reaction products of polyhydric, such as dihydric alcohols to which trihydric alcohols may be added and polybasic, such as dibasic carboxylic acids. Instead of these polycarboxylic acids, the corresponding carboxylic acid anhydrides or polycarboxylic acid esters of lower alcohols or mixtures thereof may be used for preparing the polyesters. The polycarboxylic acids can be aliphatic, cycloaliphatic, aromatic and/or heterocyclic and they can be substituted, e.g. by halogen atoms, and/or unsaturated. Non-limiting examples of suitable polycarboxylic acids include succinic acid; adipic acid; suberic acid; azelaic acid; sebacic acid; phthalic acid; isophthalic acid; trimellitic acid; phthalic acid anhydride; tetrahydrophthalic acid anhydride; hexahydro-phthalic acid anhydride; tetrachlorophthalic acid anhydride, endomethylene tetrahydrophthalic acid anhydride; glutaric acid anhydride; maleic acid; maleic acid anhydride; fumaric acid; dimeric and trimeric fatty acids such as oleic acid, which may be mixed with monomeric fatty acids; dimethyl terephthalates and bis-glycol terephthalate. Non-limiting examples of suitable polyhydric alcohols include, e.g. ethylene glycol; propylene glycol-(1,2) and-(1,3); butylene glycol-(1,4) and-(1,3); hexanediol-(1,6); octanediol-(1,8); neopentyl glycol; cyclohexanedimethanol (1,4-bis-hydroxymethyl-cyclohexane); 2-methyl-1,3-propanediol; 2,2,4-trimethyl-1,3-pentanediol; triethylene glycol; tetraethylene glycol; polyethylene glycol; dipropylene glycol; polypropylene glycol; dibutylene glycol and polybutylene glycol, glycerine and trimethlyolpropane.

Suitable polycarbonates containing hydroxyl groups include those such as the products obtained from the reaction of diols such as propanediol-(1,3), butanediol-(1,4) and/or hexanediol-(1,6), diethylene glycol, triethylene glycol or tetraethylene glycol with phosgene, diaryl-carbonates such as diphenylcarbonate or with cyclic carbonates such as ethylene or propylene carbonate. Also suitable are polyester carbonates obtained from the above-mentioned polyesters or polylactones with phosgene, diaryl carbonates or cyclic carbonates.

Suitable polyols for preparing the exemplary polyurethane polymer include polyether polyols and polysiloxane polyol, in many cases diols, having a number average molecular weight of at least 100. Also, the number average molecular weight of the polyether polyol or polysilxane diol can be up to 20,000, optionally up to 10,000, and in some cases up to 6000. The number average molecular weight of the polyether polyol or polysiloxane polyol can vary and range between any of the values recited above. The polyols can be optionally substituted with silicon atom, halogen atoms, nitro group, amino group, cyano group. Polyols can be ("can be" or "may be") substituted with halogen atoms such as chlorine and fluorine atom, and in many cases with fluorine atom. Specific examples of fluorinated polyethers are 1H, 1H, 11H,11 H-Perfluoro-3,6,9-trioxaundecane-1,11-diol (F-PEG410) (supplied by SynQuest Labs. Inc, Alachua, FL), FOMBLIN® Z DOL 2000, 2500, 4000 (available from Solvay Solexis, Inc., West Deptford, NJ). Examples of polysiloxane diols include, but are not limited to hydroxyl terminated polydimethylsiloxane such as Gelest DMS-C15, DMS-C16, DMS-C21 (available from Gelest, Inc., Morrisville, PA), SILAPLANE^{®} F-44, F-04, F-DA from Chisso (available from Chisso, Rye, NY), and aminoterminated polydimethylsiloxane such as G DMS-A11, DMS-A12, DMS-A15, DMS-A21, and DMS-A31 from Gelest, and SILAPLANE^{®} F-33 from Chisso.

In addition to the polyether polyols, minor amounts (up to 20% by weight, based on the weight of the polyol) of low molecular weight dihydric and trihydric alcohols having a molecular weight 32 to 500 can also be used. Suitable examples include ethylene glycol, 1,3-butandiol, 1,4-butandiol, 1,6-hexandiol, glycerine or trimethylolpropane.

It is also possible in accordance with embodiments of the present disclosure to use aminopolyethers instead of the polyether polyols. The aminopolyethers may be prepared by aminating the corresponding polyether polyols in known manner. In an embodiment of the disclosure, the aminopolyethers are those available under the trade name JEFFANMINE®, available from Huntsman Chemical Co., Austin, TX.

It is also possible in accordance with embodiments of the present disclosure to use aminopolysiloxane. Examples of aminopolysiloxane diols include, but are not limited to amino terminated polydimethylsiloxane such as DMS-A11, DMS-A12, DMS-A15, DMS-A21, and DMS-A31 from Gelest (available from Gelest, Inc., Morrisville, PA), and Silaplane F-33 from Chisso (available from Chisso, Rye, NY).

In an embodiment of the disclosure, the compound containing isocyanate groups as prepolymer is prepared by reacting an isocyanate component with a compound containing at least one isocyanate reactive group at an NCO:isocyanate reactive group equivalent ratio of at least 1.1:1, in some cases at least 1.25:1, and in other cases at least 1.5:1. Also, the NCO:isocyanate reactive group equivalent ratio can be up to 2:1. The NCO:isocyanate reactive group ratio can vary in a range between any of the values recited above.

In a further embodiment of the disclosure, the reaction product as prepolymer is prepared from a diisocyanate, and a diol at an NCO:OH equivalent ratio of 2:1. In this embodiment, the reaction mixture contains the 1/2 adduct of the diisocyanate and diol; minor amounts of higher molecular weight oligomers, such as the 2/3 adduct, and unreacted diisocyanate.

In another embodiment of the disclosure, the polyurethane that includes at least one pendent side chain of general formulas (1A)-(1D)is formed by reacting the above-described compound containing isocyanate groups as prepolymer with compounds containing isocyanate reactive groups. The reaction is carried out at an equivalent ratio of isocyanate groups to isocyanate-reactive groups of at least 1:0.8, or at least 1:0.9. Also the reaction can be carried out at an equivalent ratio of isocyanate groups to isocyanate-reactive groups of up to 1:1.1 or up to 1:1.05. In some cases, the reaction can be carried out at an equivalent ratio of isocyanate groups to isocyanate-reactive groups of 1:1. The reaction can be carried out at any value or can range between any values of equivalent ratio of isocyanate groups to isocyanate-reactive groups recited above. Any unreacted isocyanage end groups will be chain terminated by a compound containing mono-isocyanate reactive group.

In an embodiment of the disclosure, the reaction temperature during prepolymer production is maintained below about 150° C, or between about 20° and 130° C, or between about 20° and 100° C. The reaction is continued until the content of unreacted isocyanate groups (or isocyanate-reactive groups) decreases to the theoretical amount or slightly below.

In a further embodiment, the prepolymers may be prepared in the presence of one or more solvents, provided that the solvents are substantially nonreactive in the context of the isocyanate-polyaddition reaction. Non-limiting examples of suitable solvents include dimethylformamide, esters, ethers, ketoesters, ketones, e.g., methyl ethyl ketone and acetone, glycol-ether-esters, chlorinated hydrocarbons, aliphatic and alicyclic hydrocarbon-substituted pyrrolidinones, e.g., N-methyl-2-pyrrolidinone (NMP), hydrogenated furans, aromatic hydrocarbons and mixtures thereof.

In a particular embodiment of the disclosure, the solvents are present in the final aqueous polyurethane dispersion at a level of less than 5 wt%, in some cases less than 2 wt%, in other cases less than 1 wt% and in some situations less than 0.5 wt% of the aqueous polyurethane dispersion.

In an embodiment of the disclosure, the polyurethane is rendered water-dispersible or water-soluble by the incorporation or inclusion of hydrophilic moieties along or pendant from the polyurethane/urea chain. The presence of the hydrophilic groups enable the polyurethane to be stably dispersed in an aqueous medium. Non-limiting examples of suitable hydrophilic groups include ionic or potential ionic groups and/or lateral or terminal, hydrophilic ethylene oxide units that are chemically incorporated into the polyurethane/urea. Any suitable hydrophilic moiety can be used for this purpose. Suitable hydrophilic moieties include, but are not limited to anionic groups, cationic groups and alkylene oxide groups.

In a particular embodiment, the hydrophilic moieties are selected from lateral and terminal chains containing alkylene oxide units. As used herein, the term "alkylene oxide" refers to divalent hydrocarbons having a carbon chain length of from C₁ to C₆, which further include one or more ether oxygen atoms in the alkylene chain, non-limiting examples being the polyether segments derived from ethylene oxide, propylene oxide and butylene oxide. In a specific embodiment of the disclosure, the alkylene oxide units are ethylene oxide, or repeat units therefrom. In this embodiment, the ethylene oxide derived moieties are present at a level of at least 1 mol%, or 5 mol%, or up to 25 mol% percent based on the total repeat units of the polyurethane/urea. The ethylene oxide derived moieties can be present at any recited level or can range between any value recited above.

In an embodiment of the present disclosure, the polyurethane includes chemically incorporated anionic groups. The chemically incorporated anionic groups are suitable salts of acid groups. Further to this embodiment, the acid group in the acid salt can be, as non-limiting examples, carboxylic acid groups, sulfonic acid groups, boronic acid groups, and phosphonic acid groups. In a specific embodiment, the anionic groups include sulfonate groups, where the sulfonic acid groups make up at least 50 mol %, or at least 70 mol %, or at least 80 mol %, or at least 90 mol %, or at least 95 mol % or at least 99 mol % of the anionic groups in the polyurethane. Still further to this embodiment, the acid salt includes as a counter ion or cation, amines, including primary, secondary, and tertiary amines, ammonia, and/or alkali metal ions

In a particular embodiment of the present disclosure, the chemically incorporated cationic groups are suitable salts of amine and/or onium groups. Further to this embodiment, the onium group in the salt can be, as non-limiting examples, quaternary ammonium groups, phosphonium groups and sulfonium groups having a halide and/or methyl sulfate counter ion. As non-limiting examples, the amines can be primary, secondary and/or tertiary amines neutralized with an inorganic acid. The inorganic acid can be selected from HCl, HBr, H₂SO₄, phosphoric acid and phosphorous acid.

Suitable compounds for incorporating the carboxylate, sulfonate and quaternary nitrogen groups are described in U.S. Pat. Nos. 4,108,814, the disclosure of which is herein incorporated by reference in their entirety. Suitable compounds for incorporating tertiary sulfonium groups are described in U.S. Pat. No. 3,419,533, also incorporated by reference in its entirety. Suitable neutralizing or quaternizing agents for converting the potential anionic groups to anionic groups either before, during or after their incorporation into the polyurethane/ureas, are tertiary amines, alkali metal cations or ammonia. Examples of these neutralizing agents are disclosed in U.S. Pat. Nos. 4,501,852 and 4,701,480, which are incorporated by reference in their entirety. Suitable neutralizing agents are the trialkyl-substituted tertiary amines and include triethyl amine, N,N-dimethyl-ethanol amine, triethanol amine and N-methyl-diethanol amine. Suitable neutralizing agents for converting potential cationic groups to cationic groups are disclosed in U.S. Pat. No. 3,419,533, which is incorporated by reference in their entirety.

As used herein, the term "neutralizing agents" is meant to embrace all types of agents which are useful for converting potential ionic groups to ionic groups.

An embodiment of the present disclosure provides a method of preparing an aqueous polyurethane/urea dispersion that includes:
(i) preparing a prepolymer having at least one isocyanate group by reacting an organic isocyanate with a compound containing an one or more isocyanate reactive groups selected from--OH,--NH₂, and--SH, and optionally a low molecular weight isocyanate-reactive compound; wherein one or both of the isocyanate and the compound containing isocyanate reactive groups optionally isocyanate-reactive compounds contain hydrophilic moieties; and wherein one or both of the isocyanate and the compound containing isocyanate reactive groups optionally contain at least one pendent side chain of formulas (1A)-(1D);
(ii) optionally reacting the prepolymer in (i) with an amine chain extender having at least one pendent side chain of formulas (1A)-(1D);
(iii) optionally reacting unreacted isocyanate end group with a mono-isocyanate reactive compound as chain terminator; and
(iv) dispersing the reaction product in (II) in an aqueous medium.

In an embodiment of the disclosure, the polyurethane contains at least 5 mol% of the repeat units having the pendent side chain of formulas (1A)-(1D) based on total repeat units, at least 10 mol%, or at least 20 mol% based on total repeat units.

In an embodiment of the disclosure, the carboxylate groups for incorporation into the polyurethane are derived from hydroxy-carboxylic acids of the general formula:
(HO)ₓW(COOH)_{y}

   where W represents a straight or branched, alkyl or aralkyl radical containing 1 to 12 carbon atoms, and x and y represent integers from 1 to 3. Non-limiting examples of such hydroxy-carboxylic acids include citric acid and tartaric acid.

In a particular embodiment of the disclosure, the carboxylate groups for incorporation into the polyurethane acids are those of the above-mentioned formula wherein x=2 and y=1. These dihydroxy alkanoic acids are described in U.S. Pat. No. 3,412,054, herein incorporated by reference in its entirety. An example of a useful group of dihydroxy alkanoic acids are the dimethylol alkanoic acids represented by the structural formula Q'C(CH₂OH)₂--COOH wherein Q' is hydrogen or an alkyl group containing 1 to 8 carbon atoms. A useful compound comprises dimethylol propionic acid, i.e., when Q' is methyl in the above formula.

When incorporating the anionic or potential anionic groups through a chain extender used to convert the prepolymer to the polyurethane in the second step of the two-step process, it is desirable to use amino functional compounds containing anionic or potential anionic groups such as the diamino carboxylic acids or carboxylates disclosed in U.S. Pat. No. 3,539,483, which is hereby incorporated by reference or salts of 2,6-diamino-hexanoic acid. When sulfonate groups are desired they may be incorporated through the chain extenders using salts of isothionic acid or diamino sulfonates of the formula H₂N--A--NH-B-SO₃- where A and B represent aliphatic hydrocarbon radicals containing 2 to 6 carbon atoms, typically ethylene groups, or sulfonated aromatic diamines such as sulfonated dianilines.

Whether the ionic groups are incorporated into the polyurethane via the prepolymer or the chain extender is not critical. Therefore, the ionic groups may exclusively be incorporated via the prepolymer or via the chain extender or a portion of the ionic groups can be introduced according to each alternative.

Suitable compounds for incorporating the lateral or terminal, hydrophilic ethylene oxide units may be either monofunctional or difunctional in the context of the isocyanate-polyaddition reaction and include, but are not limited to:
i) diisocyanates which contain lateral, hydrophilic ethylene oxide units,
ii) compounds which are difunctional in the isocyanate-polyaddition reaction and contain lateral, hydrophilic ethylene oxide units,
iii) monoisocyanates which contain terminal, hydrophilic ethylene oxide units,
iv) compounds which are monofunctional in the isocyanate-polyaddition reaction and contain terminal, hydrophilic ethylene oxide units, and
v) mixtures thereof.

In a particular embodiment of the disclosure, the prepolymer is NCO-group terminated (NCO prepolymer) and can be reacted with amines either as chain terminators or chain extenders. As a non-limiting exemplary method of reacting the NCO prepolymers with amino group-containing compounds, the prepolymer is dispersed in water and then the prepolymer is reacted with amino group-containing compounds, which can be mixed with water either before, during or after dispersing the NCO prepolymer.

In an embodiment of the disclosure, branching of the polyurethane/urea can be obtained by using compounds having an amine functionality of greater than 2. In a particular embodiment the NCO prepolymers are reacted with components, which can have an average amine functionality, i.e., the number of amine nitrogens per molecule, of about 2 to 6, optionally about 2 to 4 and in some cases about 2 to 3. The desired functionalities can also be obtained by using mixtures of polyamines.

Suitable amines are include, but are not limited to hydrocarbon polyamines containing 2 to 6 amine groups, primary or secondary amine groups. The polyamines can be aromatic, aliphatic or alicyclic amines and contain 1 to 30 carbon atoms, optionally 2 to 15 carbon atoms, and in some cases 2 to 10 carbon atoms. Such polyamines can contain additional substituents provided that they are not as reactive with isocyanate groups as the primary or secondary amines.

Non-limiting examples of polyamines include those disclosed in U.S. Pat. No. 4,408,008, herein incorporated by reference in its entirety. Specific non-limiting examples of polyamines that can be usedinclude ethylene diamine, 1,6-hexane diamine, 1,2-and 1,3-propane diamine, the isomeric butane diamines, 1-amino-3-aminomethyl-3,5,5-trimethyl cyclohexane (isophorone diamine or IPDA), bis-(4-aminocyclohexyl)-methane, bis-(4-amino-3-methylcyclohexyl)-methane, xylylene diamine, α, α, α', α'-tetramethyl-1,3-and/or-1,4-xylylene diamine, 1-amino-1-methyl-4(3)-aminomethyl cyclohexane, 2,4-and/or 2,6-hexahydrotoluylene diamine, hydrazine, diethylene triamine, triethylene tetramine, tetraethylene pentamine, pentaethylene hexamine.

The amount of amino group-containing compounds to be used in accordance with the present disclosure is dependent upon the number of isocyanate groups in the NCO prepolymer. Generally, the ratio of isocyanate groups to amino groups is 1.0:0.6 to 1.0:1.1, or 1.0:0.8 to 1.0:0.98 on an equivalent basis.

The reaction between the NCO prepolymer and the amino group-containing compounds is generally conducted at temperatures of 5 to 90° C., or 20 to 80° C., or 30 to 60° C. The reaction conditions are normally maintained until the isocyanate groups are essentially completely reacted.

In an embodiment of the invention, the prepolymers can be converted into aqueous polyurethane dispersions in accordance with methods known in polyurethane chemistry and described, e.g., in "Waterborne Polyurethanes," Rosthauser et al, Journal of Industrial Textiles, Vol. 16, pg. 39-79 (1986).

In an embodiment of the disclosure, the polyurethane/ureas can be dispersed in water by either an inverse process or a direct process. In the direct process water is added to the polyurethane to initially form a water-in-oil emulsion, which after passing through a viscosity maximum, is converted into an oil-in-water emulsion. In the inverse process the polyurethane is added to water, which avoids the need to pass through the viscosity maximum.

Even though more energy is required for preparing a dispersion by the direct process, it may be necessary to use this process if the viscosity of the polymer is too high to add the polyurethane to water. A high viscosity polymer is often obtained when a fully reacted polyurethane is prepared in the organic phase, especially when only small amounts of solvent are used.

In an embodiment of the disclosure, in the direct or inverse process, chain extending amines are present in the water to complete the transformation of an isocyanate prepolymer in to polyurethane/urea. The solvent remains in the dispersion as a coalescing aide.

In an alternative embodiment of the disclosure, the chain extention is completed, in the direct or inverse process, in a solvent solution, as a non-limiting example, acetone. In this embodiment, the solvent disperses the solution in water and then the solvent is removed leaving a dispersion with zero solvent.

In an embodiment of the disclosure, the average particle size of the polyurethane particles in the aqueous dispersion is at least 0.001 microns, in some cases at least 0.01 microns. Further, the average particle size of the polyurethane particles in the aqueous dispersion is not more than 100 microns, in some cases not more than 50 microns, and in other cases not more than 25 microns. Smaller particle sizes enhance the stability of the dispersed particles and also lead to the production of films with high surface gloss. The average particle size of the polyurethane particles in the aqueous dispersion can be any value or range between any values recited above.

The polyurethane polymer of the present disclosure comprises at least one pendent side chain of the general formulas (1A) - (1 D). Specifically, the polyurethane polymer of the present disclosure comprises at least 5 mol% of repeat units incorporating pendent side chain of general formulas (1A) - (1 D). The pendent side chain can be incorporated into the polyurethane via the prepolymer synthesis step or the chain extention or chain termination step or in all steps.

Non-limiting examples of suitable monomers or polymers incorporating pendent side chain of formulas (1A) - (1 D) that can be utilized to prepare polyurethane of the present disclosure include but are not limited to the following structures, wherein X is independently of one another, and is hydrogen, a one- or multivalent cation, such as at least one member from the group of Li⁺, Na⁺, K⁺, Rb⁺, Cs⁺, TiO²⁺, ZrO²⁺, Ti⁴⁺, Zr⁴⁺, Ca²⁺, Mg²⁺ or an ammonium ion.

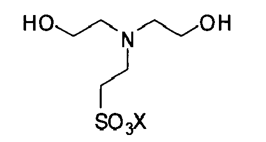

### Compound 1

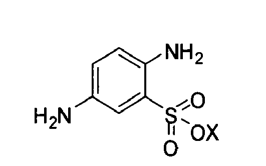

### Compound 2

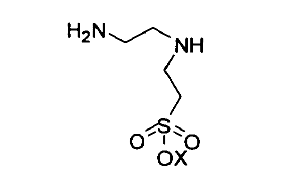

### Compound 3

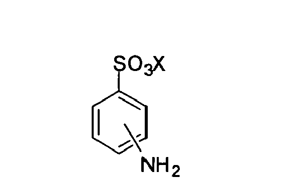

### Compound 4

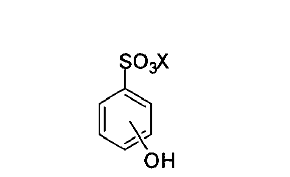

### Compound 5

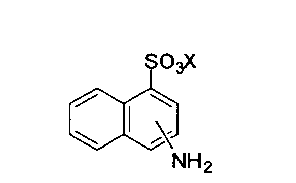

### Compound 6

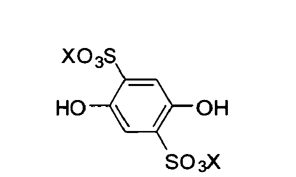

### Compound 7

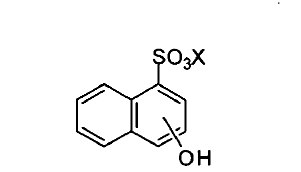

### Compound 8

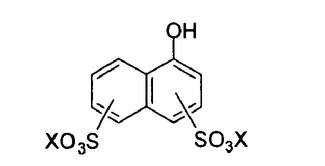

### Compound 9

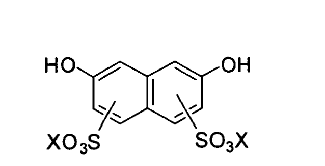

### Compound 10

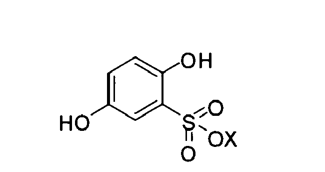

### Compound 11

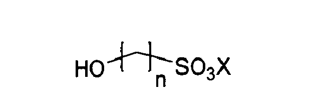

n is an interger of 1 to 10

### Compound 12

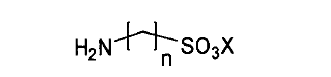

n is an interger of 1 to 10

### Compound 13

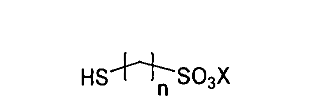

n is an interger of 1 to 10

### Compound 14

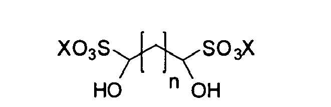

### Compound 15

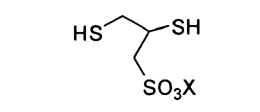

### Compound 16

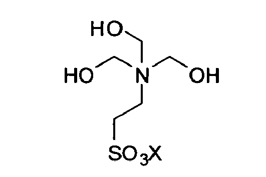

### Compound 17

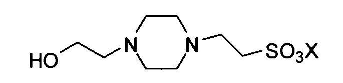

### Compound 18

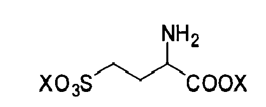

### Compound 19

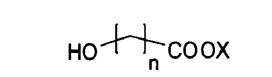

n=1-15

### Compound 20

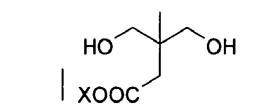

### Compound 21

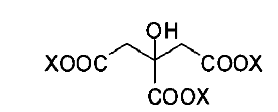

### Compound 22

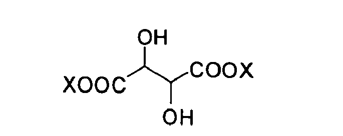

### Compound 23

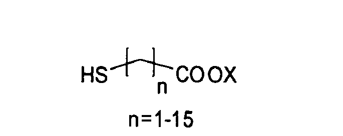

### Compound 24

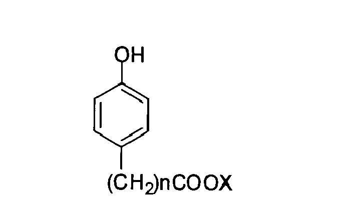

### Compound 25

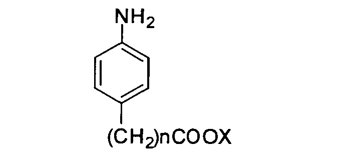

### Compound 26

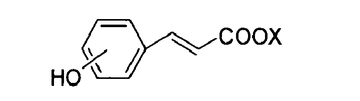

### Compound 27

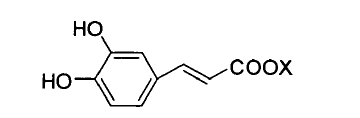

### Compound 28

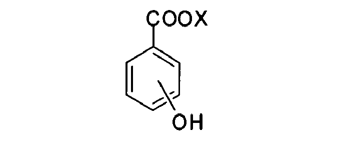

### Compound 29

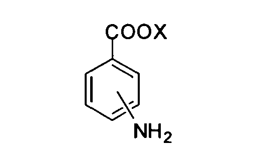

### Compound 30

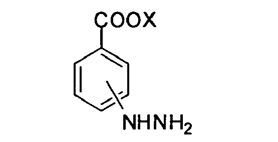

### Compound 31

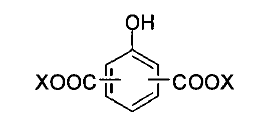

### Compound 32

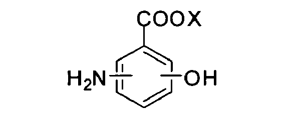

### Compound 33

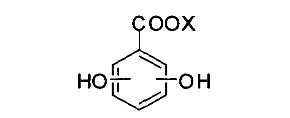

### Compound 34

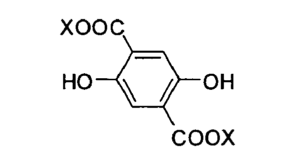

### Compound 35

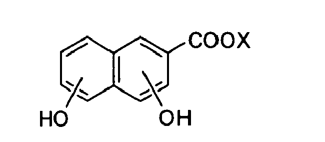

### Compound 36

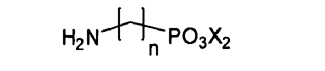

n=1-10

### Compound 37

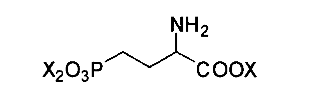

### Compound 38

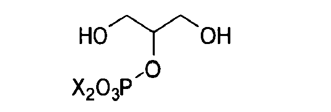

### Compound 39

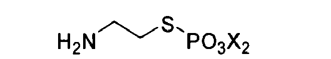

### Compound 40

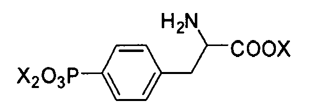

### Compound 41

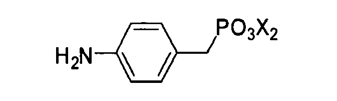

### Compound 42

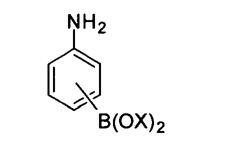

### Compound 43

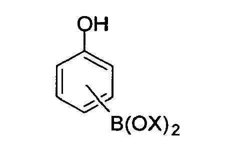

### Compound 44

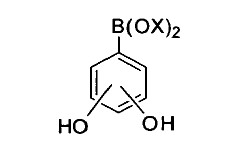

### Compound 45

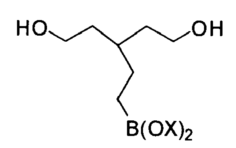

### Compound 46

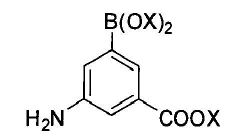

### Compound 47

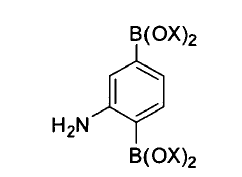

### Compound 48

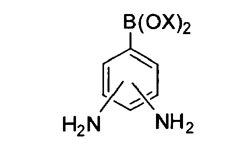

### Compound 49

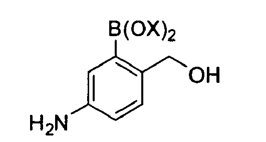

### Compound 50

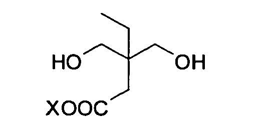

### Compound 51

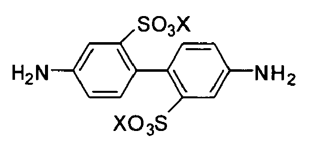

### Compound 52

The polyurethane polymer of the present disclosure comprises at least 5 mol% of repeat units incorporating pendent side chain of general formulas (1A)-(1D)based on the total repeat units of the polyurethane, in some cases at least 10 mol%, another cases at least 15 mol%, and in some situations at least 20 mol%.

In the context of the present disclosure, the number of the repeating units of the polyurethane polymer having at least one pendent side chain of general formula (1) along one macromolecule chain of the polymer can be an integer greater than or equal to 10, in particular greater than or equal to 20. Typically the polyurethane polymers of the present disclosure have a weight average molecular weight in the range of 2,000 to 1,000,000 g/mol, such as 4,000 g/mol to 500,000 g/mol.

The polyurethane polymers having at least one pendent side chain of formula formulas (1A)-(1D)that are useful in the context of the present disclosure include homopolymers and copolymers, and copolymers can be random or block or graft copolymers. The polyurethane polymers can be linear or branched.

The optional colloid-forming polymeric acids contemplated for use in the practice of the disclosure are insoluble in water, and form colloids when dispersed into a suitable aqueous medium. The polymeric acids typically have a molecular weight in the range of about 10,000 to about 4,000,000. In one embodiment, the polymeric acids have a molecular weight of about 50,000 to about 2,000,000. Any polymeric acid that is colloid-forming when dispersed in water is suitable for use in the practice of the disclosure. In one embodiment, the colloid-forming polymeric acid comprises polymeric sulfonic acid. Other acceptable polymeric acids comprise at least one member of polymer phosphoric acids, polymer carboxylic acids, and polymeric acrylic acids, and mixtures thereof, including mixtures having polymeric sulfonic acids. In another embodiment, the polymeric sulfonic acid comprises a fluorinated acid. In still another embodiment, the colloid-forming polymeric sulfonic acid comprises a perfluorinated compound. In yet another embodiment, the colloid-forming polymeric sulfonic acid comprises a perfluoroalkylenesulfonic acid.

In still another embodiment, the optional colloid-forming polymeric acid comprises a highly-fluorinated sulfonic acid polymer (FSA polymer). "Highly fluorinated" means that at least about 50% of the total number of halogen and hydrogen atoms in the polymer are fluorine atoms, and in one embodiment at least about 75%, and in another embodiment at least about 90%. In one embodiment, the polymer comprises at least one perfluorinated compound.

The optional polymeric acid can comprise sulfonate functional groups. The term "sulfonate functional group" refers to either sulfonic acid groups or salts of sulfonic acid groups, and in one embodiment comprises at least one of alkali metal or ammonium salts. The functional group is represented by the formula -SO₃X where X comprises a cation, also known as a "counterion". X can comprise at least one member selected from the group consisting of H, Li, Na, K or N(R₁")(R₂")(R₃)(R₄), and R₁", R₂", R₃, and R₄ are the same or different, and are in one embodiment H, CH₃ or C₂H₅. In another embodiment, X comprises H, in which case the polymer is said to be in the "acid form". X may also be multivalent, as represented by such ions as Ca²⁺, Al³⁺, Fe²⁺ and Fe³⁺. In the case of multivalent counterions, represented generally as Mⁿ⁺, the number of sulfonate functional groups per counterion will be equal to the valence "n".

In one embodiment, the optional FSA polymer comprises a polymer backbone with recurring side chains attached to the backbone, the side chains carrying cation exchange groups. Polymers include homopolymers or copolymers of two or more monomers. Copolymers are typically formed from a nonfunctional monomer and a second monomer carrying a cation exchange group or its precursor, e.g., a sulfonyl fluoride group (--SO₂F), which can be subsequently hydrolyzed to a sulfonate functional group. For example, copolymers comprising a first fluorinated vinyl monomer together with a second fluorinated vinyl monomer having a sulfonyl fluoride group (--SO₂F) can be used. Examples of suitable first monomers comprise at least one member from the group of tetrafluoroethylene (TFE), hexafluoropropylene, vinyl fluoride, vinylidine fluoride, trifluoroethylene, chlorotrifluoroethylene, perfluoro(alkyl vinyl ether), and combinations thereof. TFE is a desirable first monomer.

In other embodiments, examples of optional second monomers comprise at least one fluorinated vinyl ether with sulfonate functional groups or precursor groups which can provide the desired side chain in the polymer. Additional monomers include ethylene. In one embodiment, FSA polymers for use in the present disclosure comprise at least one highly fluorinated FSA, and in one embodiment perfluorinated, carbon backbone and side chains represented by the formula

--(O--CF₂CFR_{f})ₐ--O--CF₂CFR'_{f}SO₃X

wherein R_{f} and R'_{f} are independently selected from F, Cl or a perfluorinated alkyl group having 1 to 10 carbon atoms, a=0, 1 or 2, and X comprises at least one of H, Li, Na, K or N(R₁.')(R₂')(R₃)(R₄) and R₁", R₂", R₃, and R₄ are the same or different and are and in one embodiment H, CH₃ or C₂H₅. In another embodiment X comprises H. As stated above, X may also be multivalent.

In another embodiment, the optional FSA polymers include, for example, polymers disclosed in U.S. Pat. Nos. 3,282,875, 4,358,545 and 4,940,525 (all hereby incorporated by reference in their entirety). An example of a useful FSA polymer comprises a perfluorocarbon backbone and the side chain represented by the formula

--O--CF₂CF(CF₃)--O--CF₂CF₂SO₃X'

where X' is as defined above. FSA polymers of this type are disclosed in U.S. Pat. No. 3,282,875 and can be made by copolymerization of tetrafluoroethylene (TFE) and the perfluorinated vinyl ether CF₂=CF-O-CF₂CF(CF₃)-O-CF₂CF₂SO₂F, perfluoro(3,6-dioxa-4-methyl-7-octenesulfonyl fluoride) (PDMOF), followed by conversion to sulfonate groups by hydrolysis of the sulfonyl fluoride groups and ion exchanged as necessary to convert them to the desired ionic form. An example of a polymer of the type disclosed in U.S. Pat. Nos. 4,358,545 and 4,940,525 has the side chain --O--CF₂CF₂SO₃X', wherein X' is as defined above. This polymer can be made by copolymerization of tetrafluoroethylene (TFE) and the perfluorinated vinyl ether CF₂=CF--O--CF₂CF₂SO₂F, perfluoro(3-oxa-4-pentenesulfonyl fluoride) (POPF), followed by hydrolysis and further ion exchange as necessary.

In another embodiment, the optional FSA polymers include, for example, polymers disclosed in US 2004/0121210 Al; hereby incorporated by reference in its entirety. An example of a useful FSA polymer can be made by copolymerization of tetrafluoroethylene (TFE) and the perfluorinated vinyl ether CF₂=CF-O-CF₂CF₂CF₂CF₂SO₂F followed by conversion to sulfonate groups by hydrolysis of the sulfonyl fluoride groups and ion exchanged as desired to convert the fluoride groups to the desired ionic form. In another embodiment, the FSA polymers include, for example, polymers disclosed in US2005/0037265 A1; hereby incorporated by reference in its entirety. An example of a useful FSA polymer can be made by copolymerization of CF₂=CFCF₂OCF₂CF₂SO₂F and tetrafluoroethylene followed by conversion to sulfonate groups by KOH hydrolysis of the sulfonyl fluoride groups and ion exchanged with acid to convert the potassium ion salt to the acid form.

In other embodiments, the optional FSA polymers for use in this disclosure typically have an ion exchange ratio of less than about 33. "Ion exchange ratio" or "IXR" is meant as the number of carbon atoms in the polymer backbone in relation to the cation exchange groups. Within the range of less than about 33, IXR can be varied as desired for the particular application. In one embodiment, the IXR is about 3 to about 33, and in another embodiment about 8 to about 23.

The cation exchange capacity of a polymer is often expressed in terms of equivalent weight (EW). For the purposes of this application, equivalent weight (EW) is defined to be the weight of the polymer in acid form sufficient to neutralize one equivalent of sodium hydroxide. In the case of a sulfonate polymer where the polymer has a perfluorocarbon backbone and the side chain comprises --O--CF₂--CF(CF₃)--O-CF₂--- CF₂--SO₃H (or a salt thereof), the equivalent weight range which corresponds to an IXR of about 8 to about 23, is about 750 EW to about 1500 EW. IXR for this polymer can be related to equivalent weight using the formula: 50 IXR+344=EW. While the same IXR range is used for sulfonate polymers disclosed in U.S. Pat. Nos. 4,358,545 and 4,940,525 (hereby incorporated by reference in their entirety), e.g., the polymer having the side chain --O--CF₂CF₂SO₃H (or a salt thereof), the equivalent weight is somewhat lower because of the lower molecular weight of the monomer unit containing a cation exchange group. For an IXR range of about 8 to about 23, the corresponding equivalent weight range is about 575 EW to about 1325 EW. IXR for this polymer can be related to equivalent weight using the formula: 50 IXR+178=EW.

The optional FSA polymers can be prepared as colloidal aqueous dispersions. They may also be in the form of dispersions in other media, examples of which include, without limitation, alcohol, water-soluble ethers, such as tetrahydrofuran, mixtures of water-soluble ethers, and combinations thereof. In making the dispersions, the polymer can be used in acid form. U.S. Patent Nos. 4,433,082, 6,150,426 and WO 03/006537 (hereby incorporated by reference in their entirety) disclose methods for making aqueous alcoholic dispersions. After the dispersion is made, the FSA concentration and the dispersing liquid composition can be adjusted by methods known in the art.

Aqueous dispersions comprising colloid-forming polymeric acids, including FSA polymers, typically have particle sizes as small as possible, so long as a stable colloid is formed. Aqueous dispersions of FSA polymer are available commercially as NAFION^{®} dispersions, from E. I. du Pont de Nemours and Company (Wilmington, Del.). An example of a suitable FSA polymer comprises a copolymer having a structure: 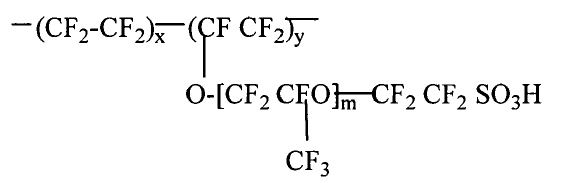 The copolymer comprises tetrafluoroethylene and perfluoro(4-methyl-3,6-dioxa-7-octene-1-sulfonic acid) wherein m = 1.

Aqueous dispersions of FSA polymer from US2004/0121210 A1 or US2005/0037265 A1 could be made by using the methods disclosed in U.S. Pat. No. 6,150,426; the disclosure of the previously identified U.S. patents and patent applications is hereby incorporated by reference in their entirety.

Other suitable FSA polymers are disclosed in U.S. Patent No. 5,422,411; hereby incorporated by reference in its entirety. One such suitable polymeric acid that can be used as counter ion/dispersant for polythiophenes can have the following structure: 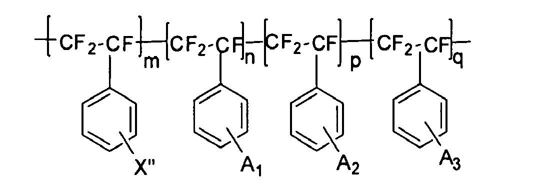 where at least two of m, n, p and q are integers greater than zero; A₁, A₂, and A₃ are selected from the group consisting of alkyls, halogens, C_{y}F_{2y+1} where y is an integer greater than zero, O-R" (where R" is selected from the group consisting of alkyl, perfluoroalkyl and aryl moieties), CF=CF₂, CN, NO₂ and OH; and X" is selected from the group consisting of SO₃H, PO₂H₂, PO₃H₂,CH₂PO₃H₂, COOH, OPO₃H₂, OSO₃H, OArSO₃H where Ar is an aromatic moiety, NR"₃⁺ (where R" is selected from the group consisting of alkyl, perfluoroalkyl and aryl moieties), and CH₂NR₃⁺ (where R" is selected from the group consisting of alkyl, perfluoroalkyl and aryl moeities). The A₁, A₂, A₃ and X" substituents may be located in the ortho, meta and/or para positions. The copolymer may also be binary, ternary or quaternary.

While any suitable non-fluorinated polymeric acid may be employed, examples of such acids comprise at least one member selected from the group consisting of poly(styrenesulfonic acid) and poly(2-acrylamido-2-methyl-1-propanesulfonic acid). The amount of non-fluorinated polymer acid typically ranges from about 0.05 wt.% to about 1.5 wt.% of the dispersion.

In one embodiment, thienothiophene or thieno[3,4-b]thiophene monomers are oxidatively polymerized in an aqueous medium comprising at least one polyurethane polymer and polymeric acid colloids. Typically, thienothiophene or thieno[3,4-b]thiophene monomers are combined with or added to an aqueous dispersion comprising at least one polymerization catalyst, at least one oxidizing agent, and colloidal polymeric acid particles. In this embodiment, the order of combination or addition may vary provided that the oxidizer and catalyst is typically not combined with the monomer until one is ready for the polymerization reaction to proceed. Polymerization catalysts include, without limitation, at least one member selected from the group consisting of ferric sulfate, ferric chloride, cerium sulfate, and the like and mixtures thereof. Oxidizing agents include, without limitation, at least one member selected from the group consisting of ferric sulfate, ferric chloride, sodium persulfate, potassium persulfate, ammonium persulfate, and the like, including combinations thereof. In some cases, the oxidant and catalyst can comprise the same compound. The oxidative polymerization results in a stable, aqueous dispersion comprising positively charged conducting polymeric thienothiophene and/or thieno[3,4-b]thiophene that is charge balanced by the negatively charged side chains of the polymeric acids contained within the colloids (e.g., sulfonate anion, carboxylate anion, acetylate anion, phosphonate anion, combinations, and the like). While any suitable process conditions can be employed for polymerizing the thienothiophene, using the temperature ranges from about 8 to about 95 °C as well as conditions and equipment sufficient to obtain, mix and maintain a dispersion are useful.

In one embodiment of the disclosure, a method of making an aqueous dispersions comprising poly(thieno[3,4-b]thiophene), at least one polyurethane polymer and at least one colloid-forming polymer acid comprises: (a) providing an aqueous dispersion comprising at least one polyurethane polymer, at least one fluorinated polymer acid and at least one non-fluorinated polymeric acid; (b) adding at least one oxidizer to the dispersion of step (a); (c) adding at least one catalyst or oxidizer to the dispersion of step (b); (d) adding thieno[3,4-b]thiophene monomer to the dispersion of step (c), (e) permitting the monomer dispersion to polymerize, and (f) adjusting the pH of the dispersion to a value sufficiently high to render the material resistivity more stable. The method may include adjusting the pH to a value greater than 3. In another embodiment, the pH value may be adjusted to greater than 6 or greater than 8. One alternative embodiment to this method comprises adding thieno[3,4-b]thiophene monomer to the aqueous dispersion of at least one polyurethane polymer and at least one polymeric acid prior to adding the oxidizer. Another embodiment, comprises forming an aqueous dispersion comprising water and thieno[3,4-b]thiophene (e.g., of any number of thieno[3,4-b]thiophene concentrations in water which is typically in the range of about 0.05% by weight to about 50% by weight thieno[3,4-b]thiophene), and add this thieno[3,4-b]thiophene mixture to the aqueous dispersion of the polymeric acid before or after adding the oxidizer and catalyst . In yet another embodiment, thienothiophene monomer is dissolved in an organic solvent that is compatible with water, and the dissolved monomer solution is added to the aqueous dispersion of polymeric acid before or after adding the oxidizer and/or catalyst.

The compositions of the present disclosure are not limited to the homopolymeric structures above and may include hetereopolymeric or copolymeric structures. The copolymeric structures may be any combination of alternating copolymers(e.g., alternating A and B units), periodic copolymers (e.g., (A-B-A-B-B-A-A-A-A-B-B-B)n, random copolymers (e.g., random sequences of monomer A and B), statistical copolymers (e.g., polymer sequence obeying statistical rules) and/or block copolymers (e.g., two or more homopolymer subunits linked by covalent bonds). The copolymers may be branched or linked, provided the resultant copolymer maintains the properties of electrical conductivity. The copolymer structures may be formed from monomeric, oligomeric or polymeric compounds. For example, monomers suitable for use in the copolymer system may include monomers such as thiophene, substituted thiophenes, substituted thieno[3,4-b]thiophenes, dithieno[3,4-b:3',4'-d]thiophene, pyrrole, bithiophene, substitued pyrroles, phenylene, substituted phenylenes, naphthalene, substituted naphthalenes, biphenyl and terphenyl, substituted terphenyl, phenylene vinylene and substituted phenylene vinylene.

In addition to thienothiophene or the thieno[3,4-b]thiophene monomers, other thiophene monomeric compounds may be utilized in the present disclosure, provided that the resultant polymer is electrically conductive and includes both fluorinated polymeric acid and non-fluorinated polymeric acid.

In some cases, the dispersion can include at least one metal (e.g., at least one ion). Examples of metals that can be added or present in the dispersion comprise at least one member selected from the group consisting of Fe²⁺, Fe³⁺, K⁺, and Na⁺, mixtures thereof, among others. The oxidizer:monomer molar ratio is usually about 0.05 to about 10, generally in the range of about 0.5 to about 5. (e.g., during the inventive polymerization steps). If desired, the amount of metal can be lowered or removed by exposing the dispersion to cationic and ionic exchange resins.

The thiophene monomer polymerization can be carried out in the presence of co-dispersing carriers or liquids which are normally miscible with water. Examples of suitable co-dispersing liquids comprise at least one member selected from the group consisting of ethers, alcohols, esters, cyclic ethers, ketones, nitriles, sulfoxides, amide, acetamide,and combinations thereof. In one embodiment, the amount of co-dispersing liquid is less than about 30% by volume. In one embodiment, the amount of co-dispersing liquid is less than about 60% by volume. In one embodiment, the amount of co-dispersing liquid is between about 5% to about 50% by volume. In one embodiment, the co-dispersing liquid comprises at least one alcohol. In one embodiment, the co-dispersing carrier or liquid comprises at least one member selected from the group of n-propanol, isopropanol, t-butanol, methanol, dimethylacetamide, dimethylformamide, N-methylpyrrolidone, and propylene glycol n-propylether. The co-dispersing liquid can comprise an organic acid such as at least one member selected from the group consisting of p-toluenesulfonic acid, dodecylbenzenesulfonic acid, methanesulfonic acid, trifluoromethanesulfonic acid, camphorsulfonic acid, acetic acid, mixtures thereof and the like. Alternatively, the acid can comprise a water soluble polymeric acid such as poly(styrenesulfonic acid), poly(2-acrylamido-2-methyl-1-propanesulfonic acid), or the like, or a second colloid-forming acid, as described above. Combinations of acids can also be used.

The organic acid can be added to the polymerization mixture at any point in the process prior to the addition of either the oxidizer or the thienothiophene monomer, whichever is added last. In one embodiment, the organic acid is added before both the thiophene monomer, at least one polyurethane polymer and the optional colloid-forming polymeric acid, and the oxidizer is added last. In one embodiment the organic acid is added prior to the addition of the thiophene monomer, followed by the addition of the colloid-forming polymeric acid, and the oxidizer is added last. In another embodiment, the polymeric co-acid can be added to the aqueous dispersion after the as-synthesized aqueous dispersion has been treated with ion exchange resin(s). The co-dispersing liquid can be added to the polymerization mixture at any point prior to the addition of the oxidizer, catalyst, or monomer, whichever is last.

In another aspect of the disclosure, after completing any of the methods described above and completion of the polymerization, the as-synthesized aqueous dispersion is contacted with at least one ion exchange resin under conditions suitable to produce a stable, aqueous dispersion. In one embodiment, the as-synthesized aqueous dispersion is contacted with a first ion exchange resin and a second ion exchange resin. In another embodiment, the first ion exchange resin comprises an acidic, cation exchange resin, such as a sulfonic acid cation exchange resin set forth above, and the second ion exchange resin comprises a basic, anion exchange resin, such as a tertiary amine or a quaternary exchange resin.

Ion exchange comprises a reversible chemical reaction wherein an ion in a fluid medium (such as an aqueous dispersion) is exchanged for a similarly charged ion attached to an immobile solid particle that is insoluble in the fluid medium. The term "ion exchange resin" is used herein to refer to all such substances. The resin is rendered insoluble due to the crosslinked nature of the polymeric support to which the ion exchanging groups are attached. Ion exchange resins are classified as acidic, cation exchangers, which have positively charged mobile ions available for exchange, and basic, anion exchangers, whose exchangeable ions are negatively charged.

Both acidic, cation exchange resins and basic, anion exchange resins can be employed in the present disclosure. In one embodiment, the acidic, cation exchange resin comprises an organic acid, cation exchange resin, such as a sulfonic acid cation exchange resin. Sulfonic acid cation exchange resins contemplated for use in the practice of the disclosure can comprise at least one member selected from the group consisting of sulfonated styrene-divinylbenzene copolymers, sulfonated crosslinked styrene polymers, phenol-formaldehyde-sulfonic acid resins, benzene-formaldehyde-sulfonic acid resins, and mixtures thereof. In another embodiment, the acidic, cation exchange resin comprises at least one organic acid, cation exchange resin, such as carboxylic acid, acrylic or phosphoric acid cation exchange resin and mixtures thereof. In addition, mixtures of different cation exchange resins can be used. In many cases, the basic ion exchange resin can be used to adjust the pH to the desired level. In some cases, the pH can be further adjusted with an aqueous basic solution such as a solution of sodium hydroxide, ammonium hydroxide, tetra-methylammonium hydroxide, tetra-ethylammonium hydroxide, calcium hydroxide, cesium hydroxide, and mixtures thereof, among others.

In another embodiment, the basic, anionic exchange resin comprises at least one tertiary amine anion exchange resin. Tertiary amine anion exchange resins contemplated for use in the practice of the disclosure can comprise at least one member selected from the group consisting of tertiary-aminated styrene-divinylbenzene copolymers, tertiary-aminated crosslinked styrene polymers, tertiary-aminated phenol-formaldehyde resins, tertiary-aminated benzene-formaldehyde resins, and mixtures thereof. In a further embodiment, the basic, anionic exchange resin comprises at least one quaternary amine anion exchange resin, or mixtures of these and among other exchange resins.

The first and second ion exchange resins may contact the as-synthesized aqueous dispersion either simultaneously, or consecutively. For example, in one embodiment both resins are added simultaneously to an as-synthesized aqueous dispersion comprising an electrically conducting polymer, and allowed to remain in contact with the dispersion for at least about 1 hour, e.g., about 2 hours to about 20 hours. The ion exchange resins can then be removed from the dispersion by filtration. This procedure can be repeated as desired in order to achieve a given ion concentration. The size of the filter is chosen so that the relatively large ion exchange resin particles will be removed while the smaller dispersion particles will pass through. Without wishing to be bound by theory or explanation, it is believed that the ion exchange resins quench polymerization and effectively remove ionic and non-ionic impurities and most of unreacted monomer from the as-synthesized aqueous dispersion. Moreover, the basic, anion exchange and/or acidic, cation exchange resins increases the pH of the dispersion. Generally, around 1-2 g of ion exchange resin per milli-equivalent oxidant is used to remove the oxidant. In one embodiment, 5-10 g of ion exchange resin is used per 1 g of Fe₂(SO₄)₃.*H₂O. In general, at least 1 gram of ion exchange resin is used per about 1 gram of colloid-forming polymeric acid . In one embodiment, about one gram of LEWATIT^{®} MP62 WS, a weakly basic anion exchange resin from Bayer GmbH, and about one gram of LEWATIT^{®} MonoPlus S100, a strongly acidic, acid cation exchange resin from Bayer, GmbH, are used per gram of the composition of poly(thieno[3,4-b]thiophene) and at least one colloid-forming polymeric acid.

In one aspect of the disclosure, the dispersion further comprises a relatively low weight percentage of highly conductive additives, can be used, as desired, to reach the percolation threshold. Examples of suitable conductive additives can comprise at least one member selected from the group consisting of metal particles and nanoparticles, nanowires, carbon nanotubes, graphite fiber or particles, carbon particles and combinations thereof.

In one embodiment of the disclosure, the cast thin film or layer of the hole injection layer is annealed typically at elevated temperatures (e.g., up to about 250 °C). By "annealing" it is meant that the film is treated under conditions necessary to impart desired properties for targeted applications, such as removal of residual solvent or moistures.

In a further aspect of the disclosure additional materials may be added. Examples of additional water soluble or dispersible materials which can be added include, but are not limited to polymers, dyes, coating aids, carbon nanotubes, nanowires, surfactants (e.g., fluorosurfactants such as ZONYL^{®} FSO series non-ionic fluorosurfactants (e.g., available commercially from DuPont, Wilmington, DE) with structure R_{f}CH₂CH₂O(CH₂CH₂O)ₓH, where R_{f} = F(CF₂CF₂)_{y}, x = 0 to about 15 and y = 1 to about 7, acetylenic diol based surfactants such as DYNOL^{™} and SURFYNOL^{®} series (e.g., available commercially from Air Products and Chemicals, Inc., Allentown, PA), organic and inorganic conductive inks and pastes, charge transport materials, crosslinking agents, and combinations thereof. The materials can be simple molecules or polymers. Examples of suitable other water soluble or dispersible polymers comprise at least one conductive polymer such as polyanilines, polyamines, polypyrroles, polyacetylenes, and combinations thereof.

In another embodiment, the disclosure relates to electronic devices comprising at least one electroactive layer (usually a semiconductor conjugated small molecule or polymer) positioned between two electrical contact layers, wherein at least one of the layers of the device includes the inventive hole injection layer. One embodiment of the present disclosure is illustrated by an OLED device, as shown in Fig. 1. Referring now to Fig 1, Fig 1 illustrates a device that comprises an anode layer 110, a hole injection layer (HIL) 120 , an electroluminescent layer (EML) 130, and a cathode layer 150. Adjacent to the cathode layer 150 is an optional electron-injection/transport layer 140. Between the hole injection layer 120 and the cathode layer 150 (or optional electron injection/transport layer 140) is the electroluminescent layer 130. Alternatively, a layer of hole transport and /or electron blocking layer, commonly termed interlayer, can be inserted between the hole injection layer 120 and the electroluminescent layer 130. An example of the benefit of using polymeric interlayer betwen HIL and EML is to improve device lifetime as well as the device efficiency. It is reported that the polymer interlayer may prevent the exciton quenching at HIL interface by acting as an efficient exciton blocking layer and the recombination zone is confined near the interlayer/emitting layer interface. Since the polymer interlayer can be easily dissolved by the solvents of the EML so that the intermixing of the interlayer with the EML may occur, the layer may be hardened and/or cross linked, for example, by thermal annealing above the glass transition temperature (Tg).

Film forming additives useful for the current disclosure can comprise organic liquids commonly characterized as solvents/humectants. These include, but are not limited to
(1) alcohols, such as methyl alcohol, ethyl alcohol, n-propyl alcohol, isopropyl alcohol, n-butyl alcohol, sec-butyl alcohol, t-butyl alcohol, iso-butyl alcohol, furfuryl alcohol, and tetrahydrofurfuryl alcohol;
(2) polyhydric alcohols, such as ethylene glycol, diethylene glycol, triethylene glycol, tetraethylene glycol, propylene glycol, polyethylene glycol, glycerol, 2-methyl-2,4-pentanediol, 1,2,6-hexanetriol, 2-ethyl-2-hydroxymethyl-1,3-- propanediol, 1,5 pentanediol, 1,2-hexanediol, and thioglycol;
(3) lower mono- and di-alkyl ethers derived from the polyhydric alcohols;
(4) nitrogen-containing compounds such as 2-pyrrolidone, N-methyl-2-pyrrolidone, and 1,3-dimethyl-2-imidazolidinone; and
(5) sulfur-containing compounds such as 2,2'-thiodiethanol, dimethyl sulfoxide and tetramethylene sulfone,
(6) ketones, ethers and esters.

Examples of polyhydric alcohols suitable for use a film forming additive include, but are not limited to, ethylene glycol, diethylene glycol (DEG), triethylene glycol, propylene glycol, tetraethylene glycol, polyethylene glycol, glycerol, 2-methyl-2,4-pentanediol, 2-ethyl-2-hydroxymethyl-1,3-propanediol(EHMP), 1,5 pentanediol, 1,2-hexanediol, 1,2,6-hexanetriol and thioglycol. Examples of lower alkyl mono- or di-ethers derived from polyhydric alcohols include, but are not limited to, ethylene glycol mono-methyl or mono-ethyl ether, diethylene glycol mono-methyl or mono-ethyl ether, propylene glycol mono-methyl, mono-ethyl and propyl ether, triethylene glycol mono-methyl, mono-ethyl or mono-butyl ether (TEGMBE), diethylene glycol di-methyl or diethyl ether, poly(ethylene glycol) monobutyl ether (PEGMBE), diethylene glycol monobutylether(DEGMBE) and propylene glycol methyl ether acetate. Commercial examples of such compounds include Dow P-series and E-series glycol ethers in the CARBITOL^{™} and DOWANOL^{®} product family, available from Dow Chemical Company, Midland, Michigan.

Examples of ketones or ketoalcohols suitable for use a film forming additive include, but are not limited to, acetone, methyl ethyl ketone and diacetone alcohol. Examples of ethers include, but not limited to tetrahydrofuran and dioxane, and examples of esters include, but not limited to ethyl lactate, ethylene carbonate and propylene carbonate.

Film forming additives useful for the current disclosure may also include at least one surfactant. The surfactants may be anionic, cationic, amphoteric or nonionic and used at levels of 0.005 to 2% of the ink composition. Examples of useful surfactants include, but not limited to, from those disclosed in U.S. Pat. Nos. 5,324,349; 4,156,616 and 5,279,654, which are herein incorporated by reference in their entirety, as well as many other surfactants known in the printing and coating art. Commercial surfactants include the SURFYNOLs^{™}, DYNOL^{™} from Air Products; the ZONYLs^{™} from DuPont and the FLUORADS^{™} (now NOVEC ^{™}) from 3M. Examples of silicon surfactants are available from BYK-Chemie as BYK surfactants, and from Crompton Corp, as SILWET^{™} surfactants. Commercially available fluorinated surfactants can be the ZONYLs^{™} from DuPont and the FLUORADS^{™} (now NOVEC ^{™}) from 3M, they can be used alone or in combination with other surfactants.

Combinations of film forming additives may also be utilized. Film forming additives can be selected (viscosity modifier, surface tension modifier) in order to provide desirable film forming properties. This can permit dispersions of the instant disclosure to be employed by electronic device manufacturers in a broad range of applications, including light emitting display, solid state lighting, photovoltaic cells and thin fim transistors.

The device may include a support or substrate (not shown) that can be adjacent to the anode layer 110 or the cathode layer 150. Most frequently, the support is adjacent the anode layer 110. The support can be flexible or rigid, organic or inorganic. Generally, glass or flexible organic films are used as a support (e.g., a flexible organic film comprising poly(ethylene terephthalate), poly(ethylene naphthalene-2.6,-dicarboxylate), and polysulfone). The anode layer 110 comprises an electrode that is more efficient for injecting holes compared to the cathode layer 150. The anode can comprise materials containing a metal, mixed metal, alloy, metal oxide or mixed oxide. Suitable materials comprise at last one member selected from the group consisting of mixed oxides of the Group 2 elements (e.g., Be, Mg, Ca, Sr, Ba, Ra), the Group 11 elements, the elements in Groups 4, 5, and 6, and the Group 8-10 transition elements (The IUPAC number system is used throughout, where the groups from the Periodic Table are numbered from left to right as 1-18 [CRC Handbook of Chemistry and Physics, 81 ^{st} Edition, 2000]). If the anode layer 110 is light transmitting, then mixed oxides of Groups 12, 13 and 14 elements, such as indium-tin-oxide, may be used. As used herein, the phrase "mixed oxide" refers to oxides having two or more different cations selected from the Group 2 elements or the Groups 12, 13, or 14 elements. Some non-limiting, specific examples of materials for anode layer 110 include, comprise at least one member selected from the group consisting of indium-tin-oxide (ITO), aluminum-tin-oxide, doped zinc oxide, gold, silver, copper, and nickel. The anode may also comprise a conductive organic material such as polyaniline, polythiophene or polypyrrole.

The anode layer 110 may be formed by a chemical or physical vapor deposition process or spin-cast process. Chemical vapor deposition may be performed as a plasma-enhanced chemical vapor deposition (PECVD) or metal organic chemical vapor deposition (MOCVD). Physical vapor deposition can include all forms of sputtering, including ion beam sputtering, as well as e-beam evaporation and resistance evaporation. Specific forms of physical vapor deposition include RF magnetron sputtering and inductively-coupled plasma physical vapor deposition (IMP-PVD). These deposition techniques are well known within the semiconductor fabrication arts.

The anode layer 110 may be patterned during a lithographic operation. The pattern may vary as desired. The layers can be formed in a pattern by, for example, positioning a patterned mask or resist on the first flexible composite barrier structure prior to applying the first electrical contact layer material. Alternatively, the layers can be applied as an overall layer (also called blanket deposit) and subsequently patterned using, for example, a patterned resist layer and wet chemical or dry etching techniques. Other processes for patterning that are well known in the art can also be used. When the electronic devices are located within an array, the anode layer 110 typically is formed into substantially parallel strips having lengths that extend in substantially the same direction.

Hole injection layer 120 includes a film formed by using the dispersion of the present disclosure. The hole injection layer 120 is usually cast onto substrates using a variety of techniques well-known to those skilled in the art. Typical casting techniques include, for example, solution casting, drop casting, curtain casting, spin-coating, screen printing, inkjet printing, gravure printing, spray coating, among others. When the hole injection layer is applied by spin coating, the viscosity and solid contents of the dispersion, and the spin rate can be employed to adjust the resultant film thickness. Films applied by spin coating are generally continuous and without pattern. Alternatively, the hole injection layer can be patterned using a number of depositing processes, such as ink jet printing such as described in U.S. Patent No. 6,087,196; hereby incorporated by reference in its entirety.

The electroluminescent (EL) layer 130 may typically be a conjugated polymer, such as poly(paraphenylenevinylene), (PPV), polyfluorene, spiropolyfluorene or other EL polymer material. The EL layer can also comprise relatively small molecules fluorescent or phosphorescent dye such as 8-hydroxquinoline aluminum (Alq₃) and tris(2-(4-tolyl)phenylpyridine) Iridium (III), a dendrimer, a blend that contains the above-mentioned materials, and combinations. The EL layer can also comprise inorganic quantum dots or blends of semiconducting organic material with inorganic quantum dots. The particular material chosen may depend on the specific application, potentials used during operation, or other factors. The EL layer 130 containing the electroluminescent organic material can be applied from solutions by any conventional technique, including spin-coating, casting, and/or printing. The EL organic materials can be applied directly by vapor deposition processes, depending upon the nature of the materials. In another embodiment, an EL polymer precursor can be applied and then converted to the polymer, typically by heat or other source of external energy (e.g., visible light or UV radiation).

Optional layer 140 can function both to facilitate electron injection/transport, and can also serve as a confinement layer to prevent quenching reactions at layer interfaces. That is, layer 140 may promote electron mobility and reduce the likelihood of a quenching reaction that can occur when layers 130 and 150 are in direct contact. Examples of materials for optional layer 140 comprise at least one member selected from the group consisting of metal-chelated oxinoid compounds (e.g., Alq₃ or the like); phenanthroline-based compounds (e.g., 2,9-dimethyl-4,7-diphenyl-1,10-phenanthroline (DDPA), 4,7-diphenyl-1,10-phenanthroline (DPA), or the like); azole compounds (e.g., 2-(4-biphenylyl)-5-(4-t-butylphenyl)-1,3,4-- oxadiazole (PBD or the like), 3-(4-biphenylyl)-4-phenyl-5-(4-t-butylphenyl)-1,2,4-triazole (TAZ or the like); other similar compounds; or any one or more combinations thereof. Alternatively, optional layer 140 may be inorganic and comprise BaO, CaO, LiF, CsF, NaCl, Li₂O, mixtures thereof, among others.

The cathode layer 150 comprises an electrode that is particularly efficient for injecting electrons or negative charge carriers. The cathode layer 150 can comprise any suitable metal or nonmetal having a lower work function than the first electrical contact layer (in this case, the anode layer 110). As used herein, the term "lower work function" is intended to mean a material having a work function no greater than 4.4 eV. As used herein, "higher work function" is intended to mean a material having a work function of at least 4.4 eV.

Materials for the cathode layer can be selected from alkali metals of Group 1 (e.g., Li, Na, K, Rb, Cs,), the Group 2 metals (e.g., Mg, Ca, Ba, or the like), the Group 12 metals, the lanthanides (e.g., Ce, Sm, Eu, or the like), and the actinides (e.g., Th, U, or the like). Materials such as aluminum, indium, yttrium, and combinations thereof, may also be used. Specific non-limiting examples of materials for the cathode layer 150 comprise at least one member selected from the group consisting of calcium, barium, lithium, cerium, cesium, europium, rubidium, yttrium, magnesium, samarium, and alloys and combinations thereof. When a reactive low work function metal such as Ca, Ba or Li is used, an overcoat of a more inert metal, such as silver or aluminum, can be used to protect the reactive metal and lower the cathode resistance.

The cathode layer 150 is usually formed by a chemical or physical vapor deposition process. In general, the cathode layer will be patterned, as discussed above in reference to the anode layer 110. If the device lies within an array, the cathode layer 150 may be patterned into substantially parallel strips, where the lengths of the cathode layer strips extend in substantially the same direction and substantially perpendicular to the lengths of the anode layer strips. Electronic elements called pixels are formed at the cross points (where an anode layer strip intersects a cathode layer strip when the array is seen from a plan or top view). For top emitting devices, a very thin layer of low work function metal such as Ca and Ba combined with a thicker layer transparent conductor such as ITO can be used as transparent cathode. Top emitting devices are beneficial in active matrix display because larger aperture ratio can be realized. Examples of such devices are described in "Integration of Organic LED's and Amorphous Si TFT's onto Flexible and Lightweight Metal Foil Substrates"; by C. C. Wu et al; IEEE Electron Device Letters, Vol. 18, No. 12, December 1997, hereby incorporated by reference in its entirety.

In other embodiments, additional layer(s) may be present within organic electronic devices. For example, a layer (not shown) between the hole injection layer 120 and the EL layer 130 may facilitate positive charge transport, energy-level matching of the layers, function as a protective layer, among other functions. Similarly, additional layers (not shown) between the EL layer 130 and the cathode layer 150 may facilitate negative charge transport, energy-level matching between the layers, function as a protective layer, among other functions. Layers that are known in the art can be also be included. In addition, any of the above-described layers can be made of two or more layers. Alternatively, some or all of inorganic anode layer 110, the hole injection layer 120, the EL layer 130, and cathode layer 150, may be surface treated to increase charge carrier transport efficiency. The choice of materials for each of the component layers may be determined by balancing the goals of providing a device with high device efficiency and longer device lifetime with the cost of manufacturing, manufacturing complexities, or potentially other factors.

The different layers may have any suitable thickness. Inorganic anode layer 110 is usually no greater than approximately 500 nm, for example, approximately 10-200 nm; hole injection layer 120, is usually no greater than approximately 300 nm, for example, approximately 30-200 nm; EL layer 130, is usually no greater than approximately 1000 nm, for example, approximately 30-500 nm; optional layer 140 is usually no greater than approximately 100 nm, for example, approximately 20-80 nm; and cathode layer 150 is usually no greater than approximately 300 nm, for example, approximately 1-150 nm. If the anode layer 110 or the cathode layer 150 is to transmit at least some light, the thickness of such layer may not exceed approximately 150 nm.

Depending upon the application of the electronic device, the EL layer 130 can be a light-emitting layer that is activated by signal (such as in a light-emitting diode) or a layer of material that responds to radiant energy and generates a signal with or without an applied potential (such as detectors or photovoltaic cells). The light-emitting materials may be dispersed in a matrix of another material, with or without additives, and may form a layer alone. The EL layer 130 generally has a thickness in the range of approximately 30-500 nm.

Examples of other organic electronic devices that may benefit from having one or more layers comprising the aqueous dispersion of the instant disclosure comprise: (1) devices that convert electrical energy into radiation (e.g., a light-emitting diode, light emitting diode display, or diode laser), (2) devices that detect signals through electronics processes (e.g., photodetectors (e.g., photoconductive cells, photoresistors, photoswitches, phototransistors, phototubes), IR detectors), (3) devices that convert radiation into electrical energy, (e.g., a photovoltaic device or solar cell), and (4) devices that include one or more electronic components that include one or more organic semi-conductor layers (e.g., a transistor or diode).

Organic light emitting diodes (OLEDs) inject electrons and holes from the cathode 150 and anode 110 layers, respectively, into the EL layer 130, and form negative and positively charged polarons in the polymer. These polarons migrate under the influence of the applied electric field, forming an exciton with an oppositely charged polarons and subsequently undergoing radiative recombination. A sufficient potential difference between the anode and cathode, typically less than approximately 12 volts, and in many instances no greater than approximately 5 volts, may be applied to the device. The actual potential difference may depend on the use of the device in a larger electronic component. In many embodiments, the anode layer 110 is biased to a positive voltage and the cathode layer 150 is at substantially ground potential or zero volts during the operation of the electronic device. A battery or other power source(s), not shown, may be electrically connected to the electronic device as part of a circuit.

The fabrication of full-color or area-color displays using two or more different light-emitting materials becomes complicated if each light-emitting material employs a different cathode material to optimize its performance. Display devices typically comprise a multiplicity of pixels which emit light. In multicolor devices, at least two different types of pixels (sometimes referred to as sub-pixels) are emitting light of different colors. The sub-pixels are constructed with different light-emitting materials. It is desirable to have a single cathode material that gives good device performance with all of the light emitters. This minimizes the complexity of the device fabrication. It has been found that a common cathode can be used in multicolor devices where the hole injection layer is made from the aqueous dispersion according to embodiments of the present disclosure. The cathode can be made from any of the materials discussed above; and may be barium, overcoated with a more inert metal such as silver or aluminum.

Other organic electronic devices that may benefit from having one or more layers comprising an aqueous dispersion of conductive polymer, including poly(thieno[3,4-b]thiophene), and at least one colloid-forming polymeric acid and at least one non-fluorinated polymeric acid include: (1) devices that convert electrical energy into radiation (e.g., a light-emitting diode, light emitting diode display, or diode laser), (2) devices that detect signals through electronics processes (e.g., photodetectors (e.g., photoconductive cells, photoresistors, photoswitches, phototransistors, phototubes), IR detectors), (3) devices that convert radiation into electrical energy, (e.g., a photovoltaic device or solar cell), and (4) devices that include one or more electronic components that include one or more organic semi-conductor layers (e.g., a transistor or diode).

If desired, the hole injection layer can be overcoated with a layer of conductive polymer applied from aqueous solution or solvent. The conductive polymer can facilitate charge transfer and also improve coatability. Examples of suitable conductive polymers comprise at least one member selected from the group consisting of polyanilines, polythiophenes, polypyrroles, polyacetylenes, polythienothiophene/polystyrenesulfonic acid, polydioxythiophene/polystyrenesulfonic acid, polyaniline-polymeric-acid-colloids, PEDOT-polymeric-acid-colloids and combinations thereof.

In yet another embodiment, the disclosure relates to thin film field effect transistors comprising electrodes obtained from the inventive dispersion. For use as electrodes in thin film field effect transistors, the conducting polymers and the liquids for dispersing or dissolving the conducting polymers are compatible with the semiconducting polymers and the solvents (e.g., to prevent re-dissolution of the polymers or semiconducting polymers). Thin film field effect transistor electrodes fabricated from conducting polymers should have a conductivity greater than about 10 S/cm. However, electrically conducting polymers made with water soluble polymeric acids usually provide conductivity in the range of about 10⁻³ S/cm or lower. Thus, in one embodiment of the disclosure, the electrodes comprise at least one polythiophene, at least one polyurethane polymer and optionally fluorinated colloid-forming polymeric sulfonic acids in combination with electrical conductivity enhancers such as nanowires, carbon nanotubes, among others. In still another embodiment of the disclosure, the electrodes comprise poly(thieno[3,4-b]thiophene), at least one polyurethane polymer and colloid-forming perfluoroethylenesulfonic acid in combination with electrical conductivity enhancers such as nanowires, carbon nanotubes, among others. Exemplary compositions may be used in thin film field effect transistors as gate electrodes, drain electrodes, or source electrodes.

In organic thin film transistor (OFTFT) devices, charge injection from source electrode to the channel material can be limited due to the mismatch of the work function of the electrode and the energy level of the channel material, which results in a significant voltage drop at the contact between the electrode and the channel material. As a result, apparent charge mobility becomes low, and the OTFT device passes low current. Similar to the application as hole injection layer in OLED, a thin layer of the inventive conductive polymer film can be applied between the source or drain electrode and the channel material of an OTFT device, to improve the energy level match, reduce the contact voltage drop and improve charge injection. As a result, higher current and higher charge mobility can be achieved in the OTFT device.

The invention will now be described in greater detail by reference to the following non-limiting examples. The following examples described certain embodiments of the present invention and shall not limit the scope of the claims appended hereto.

### EXAMPLES

The invention and its advantages are further illustrated by the following specific examples.

### Example A: synthesis of polyurethane polymers

A general procedure for the synthesis of polyurethane polymer is outlined below and the polyurethane polymer synthesized according to the present disclosure is summarized in TABLE 1.

### Prepolymer synthesis

**1.** Polyol and diisocyanate, and optional solvent were added into the reactor and stirred. The temperature of the reactor was slowly increased to 40°C to dissolve the polyol.
**2.** After the reactants became a homogeneous mixture, 1 drop of dibutyltin dilaurate (DBTDL T-12, less than 0.1 wt% was sufficient) was added into the reactor. The temperature of the reaction was permitted to increase to 50-80°C (122-176°F) due to the exothermic nature of this reaction. The temperature was controlled by circulating water.
**3.** The temperature of the reaction was maintained about 40°C (104°F) until the theoretical NCO number is reached. It usually took about 1 hour.
**4.** After theoretical NCO number was reached, the reaction temperature was lowered to room temperature and acetone was added to dilute the prepolymer to 50 wt%

### Chain extension and termination

**1.** Optionally, diamine chain extender EES-200L was then added into the reactor.
**2.** Optionally after the chain extention reaction with EES-200L, a chain terminator taurine-Na+ as a 20 wt% aqueous solution was added to terminate the reaction.
**3.** The reaction was diluted with equal amount of water and acetone, optionally tetrahydrofuran (THF) until it was clear, usually at about 20% solid.
**4.** Acetone was removed under reduced pressure. Ionic impurities were removed by equal amount of ion exchange resins AMBERLITE® IR-120 cation exchange resin (Sigma-Aldrich Chemical Co) and 94.0 grams of LEWATIT® MP-62 anion exchange resin (Fluka, Sigma-Aldrich Chemical Co)IR-120 and MP-62 to yield clear aqueous dispersion.
**5.** The polyurethane dispersion was analyzed by analytical techniques to determine molecular weight, cation and anionic impurities, and residual solvents, pH, viscosity, particle size, and work function.

Alternatively, if a high boiling point (e.g., boiling point higher than 100 °C) solvent was used for prepolymer synthesis, at the end of step 6 above, polymer was precipitated in ether or THF. Polymer was collected by filtration, washed thoroughly with ether or THF and dried. Polymer was then dissolved in acetone and equal volume of water and acetone was removed under reduced pressure. Ionic impurities were removed by ion exchange resins IR-120 and MP-62 to yield clear aqueous solution.

The chemical structures utilized in example A have the following structures:

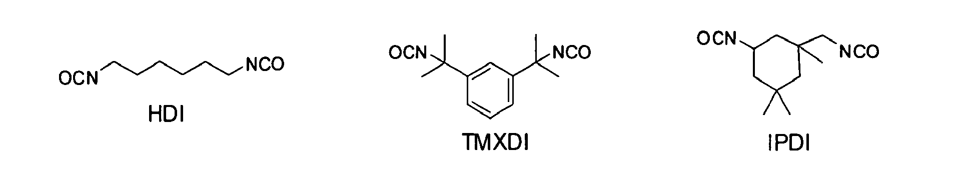

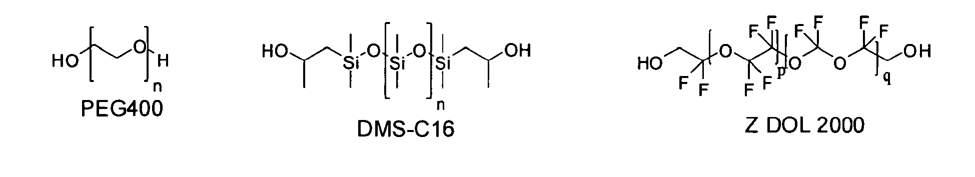

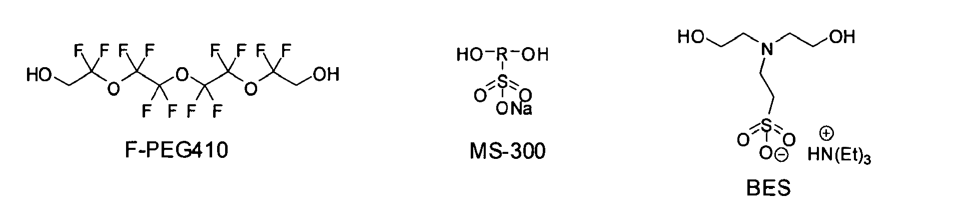

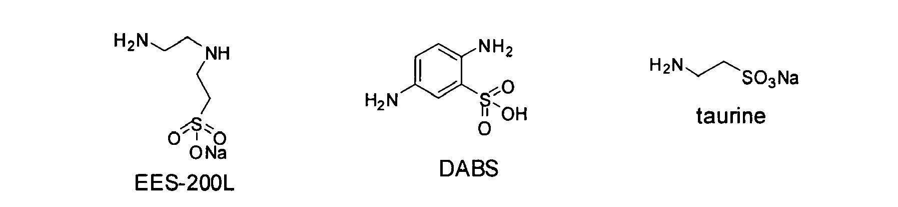

**TABLE 1. Synthesis of polyurethane polymers**

| | prepolymer | | | | Chain extension/termination | | |
|---|---|---|---|---|---|---|---|
| ID | diisocyanate | Polyol-1 | Polyol-2 | solvent | Diamine | Mono-amine | solvent |
| PU14 | HDI | PEG400 | BES | DMAc^{*} | | | |
| amt. (g) | 20.2 | 11.5 | 27.0 | 117 | | | |
| amt. (mol) | 0.12 | 0.029 | 0.086 | | | | |
| PU16 | HDI | | BES | DMAc^{*} | | | |
| amt. (g) | 22.6 | | 40.3 | 200 | | | |
| amt. (mol) | 0.13 | | 0.13 | | | | |
| PU19 | HDI | PEG400 | | | EES-200L | | acetone/ water |
| amt. (g) | 21.0 | 11.9 | | | 17.0 | | 100g/100g |
| amt. (mol) | 0.12 | 0.03 | | | 0.09 | | |
| PU25 | TMXDI | F-PEG410 | | acetone | EES-200L | | acetone/ water |
| amt. (g) | 2.6 | 1.0 | | | 1.4 | | 10/10 |
| amt. (mol) | 0.01 | 0.0024 | | | 0.075 | | |
| PU26 | IPDI | F-PEG410 | | | EES-200L | | 10/10 |
| amt. (g) | 2.4 | 1.1 | | | 1.5 | | |
| amt. (mol) | 0.011 | 0.0027 | | | 0.078 | | |
| PU31 | HDI | F-PEG410 | | | DABS | | acetone/ water |
| amt. (g) | 16.8 | 9.76 | | | 14.3 | | 20/30 |
| amt. (mol) | 0.1 | 0.024 | | | 0.076 | | |
| PU33 | HDI | MS-300 | | acetone | | | |
| amt. (g) | 21.5 | 38.5 | | 40 | | | |
| amt. (mol) | 0.13 | 0.12 | | | | | |
| PU40 | HDI | | | | EES-200L | | |
| amt. (g) | 38.5 | | | | 41.5 | | |
| amt. (mol) | 0.23 | | | | 0.022 | | |
| PU43 | HDI | DMS-C16 | | | EES-200L | taurine | acetone/ water |
| amt. (g) | 23.5 | 15.0 | | | 21.5 | 1.2 | 54/63 |
| amt. (mol) | 0.14 | 0.019 | | | 0.11 | 0.008 | |
| PU44 | HDI | DMS-C16 | | | EES-200L | taurine | acetone/ water |
| amt. (g) | 25.1 | 10.7 | | | 24.3 | 1.1 | 100/90 |
| amt. (mol) | 0.15 | 0.014 | | | 0.13 | 0.008 | |
| PU47 | HDI | F-PEG410 | | | EES-200L | taurine | acetone/ water |
| amt. (g) | 20.9 | 12.2 | | | 16.9 | 1 | 120/100 |
| amt. (mol) | 0.12 | 0.03 | | | 0.089 | 0.007 | |

| | | | | | | | |
|---|---|---|---|---|---|---|---|
| ^{*} DMAc: dimethylacetamide | | | | | | | |

The polyurethane polymer aqueous dispersion formed was analyzed for residual metal ions by Inductively Coupled Plasma Mass Spectrometry (ICP-MS), anion by ion chromatography (IC), and residual solvent by headspace GC:

PU19: ICP-MS: Al (<0.1 ppm); Ba (<0.1 ppm); Ca (<20 ppm); Cr (<0.1 ppm), Fe (<0.1 ppm); Mg (<2 ppm); Mn (<0.1 ppm); Ni (<0.1 ppm); Zn (<0.1 ppm); Na (111 ppm); K (<0.1 ppm). IC: chloride 31 ppm, sulfate 99 ppm, nitrate 5 ppm, phosphate 44ppm. Headspace GC: 67ppm THF.

PU40: ICP-MS: Al (<0.1 ppm); Ba (<0.008 ppm); Ca (<0.2 ppm); Cr (<0.06 ppm), Fe (<0.2 ppm); Mg (<0.1 ppm); Mn (<0.02 ppm); Ni (<0.2 ppm); Zn (<0.2 ppm); Na (111 ppm); K (<0.1 ppm). IC: chloride 1 ppm, sulfate 2 ppm. Headspace GC: 18 ppm acetone.

PU42: ICP-MS: AI (<1 ppm); Ca (<6 ppm); Cr (<0.1 ppm), Fe (<1 ppm); Mg (1 ppm); Mn (0.3 ppm); Ni (<0.2 ppm); Zn (<0.3 ppm); Na (109 ppm); K (9 ppm). IC: chloride 5 ppm, sulfate 22 ppm. Headspace GC: 40 ppm acetone, 5 ppm THF.

PU47: ICP-MS: Al (<0.4 ppm); Ca (<6 ppm); Cr (<0.1 ppm), Fe (<0.1 ppm); Mg (0.4 ppm); Mn (<0.2 ppm); Ni (<0.2 ppm); Zn (<0.3 ppm); Na (144 ppm); K (5 ppm). IC: chloride 5 ppm, sulfate 6 ppm. Headspace GC: 19 ppm acetone, 137 ppm THF.

### Example B: Synthesis of Conductive Polymer Dispersions

A general procedure was utilized to synthesize conductive polymer dispersions of the present disclosure.

In all examples, 3,4-Ethylenedioxythiophene (EDOT) or thieno[3,4-b]thiophene (TT) was used as monomer for synthesis of conductive polymer dispersion. To a round bottom flask was added an amount of EDOT or TT, water, and polyurethane polymer. The mixture was stirred for 5 minutes. To a separate container was added ferric sulfate and water. To another separate container was added sodium persulfate and water if sodium persulfate was present in the polymerization. Aqueous ferric sulfate solution was then added to the EDOT/polymer mixture under vigorous stirring, followed by addition of persulfate solution if applicable. The polymerization was carried out at room temperature for designated amount of time and stopped by adding ion exchange resin (IEX). After removal of resin by filtration, the dark dispersion was sonicated if necessary and then filtered through 0.45 micron PVDF (polyvinylidene difluoride) filter. The polymerization results were summarized in TABLES 2-4.

**TABLE 2: Synthesis of PEDOT/PU19 and PEDOT/PU40 conductive dispersions.**

| Dispersion ID | A | B | C | D | E |
|---|---|---|---|---|---|
| EDOT/polyurethane ratio | 1:10 | 1:6 | 1:6 | 1:6 | 1:6 |
| polyurethane | PU19 | PU19 | PU19 | PU40 | PU40 |
| %solid of polyurethane | 9.2% | 8% | 8% | 11.4% | 11.4% |
| EDOT | 0.219 g | 0.365 g | 0.359 g | 0.356 g | 0.348 g |
| polyurethane | 23.8 g | 27.4 g | 26.9 g | 18.8 g | 18.4 g |
| H₂O | 36.6 g | 37.5 g | 41.5 g | 43.9 g | 47.5 g |
| Ferric Sulfate | 0.94 g | 1.7 g | 0.16 g | 1.68 g | 0.15 g |
| H₂O | 10g | 10g | 5g | 10g | 5g |
| Sodium Persulfate | 0.40 | 0.73 g | 0.72g | 0.71 | 0.70 |
| H₂O | 10g | 10g | 10g | 10g | 10g |
| polymerization time | 24 h | 24 h | 24 h | 24 h | 24 h |
| Resistivity (Ohm.cm) | 1.01 E+ 6 | 1.65E+2 | 1.27E+4 | 1.78E+3 | 3.43E+3 |

**TABLE 3: Synthesis of PEDOT/PU47 conductive dispersions.**

| Dispersion ID | F | G | H | I |
|---|---|---|---|---|
| EDOT/polyurethane | 1:6 | 1:6 | 1:10 | 1:10 |
| ratio | | | | |
| %solid of polyurethane | 8.3% | | | |
| EDOT | 0.356 g | 0.364 g | 0.233 g | 0.239 g |
| polyurethane | 25.7g | 13g | 28.1 g | 28.9 g |
| H₂O | 37.0 g | 43.3 g | 37.1 g | 43.6 g |
| Ferric Sulfate | 1.7 g | 0.16 g | 1.1 g | 0.10 g |
| H₂O | 10g | 5g | 10g | 5g |
| Sodium Persulfate | 0.72 g | 0.73 g | 0.47 g | 0.48 g |
| H₂O | 10g | 10g | 10g | 10g |
| polymerization time (h) | 24 h | 24 h | 24 h | 24 h |
| Resistivity (Ohm.cm) | 8.25E+1 | 4.92E+2 | 6.89E+2 | 5.66E+4 |

**TABLE 4: Synthesis of PTT/47PU conductive dispersions.**

| Dispersion ID | J | K |
|---|---|---|
| TT/polyurethane ratio | 1:6 | 1:6 |
| | | |
| %solid of polyurethane | 8.3% | |
| TT | 0.434 g | 0.447 g |
| polyurethane | 31.4 g | 32.3 g |
| H₂O | 49.5 g | 51.5 g |
| Ferric Sulfate | 2.1 g | 0.20 g |
| H₂O | 10g | 10g |
| Sodium Persulfate | 0.87 g | 0.90 g |
| H₂O | 10g | 10g |
| polymerization time | 24 h | 24 h |
| Resistivity (Ohm.cm) | 7.93E+5 | 7.20E+4 |

Synthesis of conductive polymer dispersion C-A1 (PEDOT//NAFION^{®} 18:1)

1700 grams of deionized water was added to a 3 L jacketed reactor. 600 grams of a 12% NAFION® (EW 1100 supplied by the DuPont Company, Wilmington, DE) dispersion in water was added to the reactor and mixed for 5 minutes with an overhead stirrer. The jacketed flask was adjusted to maintain a 22°C (72°F) reaction temperature. 4.0 grams (28.6 mmol) of EDOT was separately co-fed into the reactor with 17.7 grams (34.2 mmole) of Fe₂(SO4)₃*H₂O dissolved in 350 grams of deionized water. NAFION^{®} to EDOT weight ratio of at charge was 18:1. The reaction mass turned from light green to emerald green to dark blue within 20 minutes. Polymerization was allowed to proceed for 4 hours after the introduction of monomer and oxidant. The resulting dispersion was then purified by adding the contents of the reactor to a 4L NALGENE® bottle containing 94.0 grams of AMBERLITE® IR-120 cation exchange resin (Sigma-Aldrich Chemical Co) and 94.0 grams of LEWATIT® MP-62 anion exchange resin (Fluka, Sigma-Aldrich Chemical Co), resulting in an opaque dark blue aqueous poly(thieno[3,4-b]thiophene)/NAFION^{®} (PTT/ NAFION^{®} dispersion. The dispersion was filtered sequentially through 10, 5, 0.65 and 0.45 micron pore size filters.

### Preparation of cleaned Amberlite^{®} IR120-Na Exchange Resin

A 500 mL polybottle was charged with 202 g of ion exchange resin, AMBERLITE^{®} IR120 in the sodium form, and 300 mL of electronic grade water (AMBERLITE^{®} is a federally registered trademark of Rohm & Haas Company , Philadelphia, PA for ion exchange resin). The material charge was allowed to soak without stirring at 20-24°C (68-75°F), for between one and four hours, after which the resin was collected on a 60 mesh stainless steel screen. This washing step was repeated for a total of five times at room temperature, followed by three more washes using same quantity of materials except the mixture was heated at 70° C (158°F) for 2 hours. The resin was finally collected on a 60 mesh screen to produce cleaned IR120-Na with 55.2% solids.

### Preparation of cleaned AMBERLITE^{®} IR120-NH₄ Exchange Resin

A 500 mL polybottle was charged with 100 g of ion exchange resin, AMBERLITE^{®} IR120 in the hydrogen form, 300 mL of electronic grade water, and 100 mL of concentrated (28-30%) ammonium hydroxide. The material charge was mixed for 16 hours on a jar roller at 20-24°C (68-75°F), after which the resin was collected on a 60 mesh stainless steel screen. The resin was then washed by soaking in 300 mL of electronic grade water without stirring for between one and four hours. This washing step was repeated for a total of five times at room temperature, followed by three more washes using same quantity of materials except the mixture was heated at 70°C (158°F) for 2 hours. The resin was finally collected on a 60 mesh screen to produce cleaned IR120-NH₄ with 56.9% solids.

### Resistivity Test

The resistivity of conductive polymer films cast from the dispersions were measured using ITO interdigitated electrodes on glass substrates. The effective electrode length was 15 cm and the gap between fingers was 20 micron. The dispersions were filtered with 0.45 micron hydrophilic PVDF filters and spin coated, at a spin rate of 1000 rpm for 1 min, onto the ITO interdigitated substrates for resistivity measurement. Before spin coating, the ITO substrates were cleaned with UV-ozone treatment on a UVOCZ equipment. The spin coated films were then transferred into a nitrogen filled glove box and measured for resistivity using a Keithley 2400 SourceMeter and a automatic switch that were interfaced with a computer using a LabVIEW program developed in house. Then the films were annealed on a hotplate at 180 °C (356°F) for 15 min in the nitrogen filled glovebox, and the resistivities measured again.

### Device Test

Patterned ITO substrates with surface resistance of 10-15 ohm/square (from Colorado Concept Coatings LLC) were used to fabricate PLED devices. The ITO substrates were cleaned by a combination of de-ionized water, detergent, methanol and acetone. Then the ITO substrates were cleaned with O₂ plasma in an SPI Prep II plasma etcher for about 10 min. After that, the ITO substrate was spin coated with conductive polymer dispersions at selected spin speed in order to obtain a film thickness of around 50-100 nm. The spin length is programmed to be between 1 to 3 mins on a Laurell Model WS-400-N6PP spinner. All conductive poymer dispersions were filtered with a 0.45 micron PVDF hydrophilic filter before spin coating. A uniform film was obtained. The coated ITO substrates were then annealed at 180 °C (356°F) for 15 min on a hotplate in a nitrogen filled glove box. After annealing, a layer (supplied by Sumitomo Chemical Company) of about 10-20nm thick interlayer polymer was spin-coated from tolune or xylene solution. The samples were then baked at 180 to 200° C (356-392° F) for 30-60 mins on a hotplate under N₂ protection. After that, a layer of about 50-90 nm thick blue light emitting polymer (supplied by Sumitomo Chemical Company) was spin coated from toluene or xylene solution. The samples were then baked at 130° C (266° F) for 10 mins on a hotplate under N₂ protection. Alternatively,green PLED devices were fabricated. After the annealing of the conductive polymer layer, a layer of about 80-nm-thick LUMATION^{®} Green 1304 LEP light emitting polymer (supplied by Sumitomo Chemical Company) was spin coated from toluene solution. The samples were then baked at 130 °C (266° F) for 20 min on a hotplate under N₂ protection. The samples were then transferred into the chamber of a vacuum evaporator, which was located inside an nitrogen atmosphere glove box. A layer of 5 nm thick Ba was vacuum deposited at below 1-2×10⁻⁶ mBar through a mask at a rate of ∼1.5 Å/s, and another layer of 120 nm thick Ag was vacuum deposited on top of the Ba layer at a deposition rate of ∼3.0-4.0 A/s. The devices were then encapsulated with glass cover lid and UV curable epoxy in the nitrogen glove box. The active area of the device was about 6.2 mm². The LED device was then moved out of the glove box for testing in air at room temperature. Thickness was measured on a KLA Tencor P-15 Profiler. Current-voltage characteristics were measured on a Keithley 2400 SourceMeter. Electroluminescence (EL) spectrum of the device was measured using an Oriel InstaSpec IV CCD camera and is illustrated in FIG. 3 in U.S Patent Applications US20060076557 A1, which is hereby incorporated by reference in its entirety. The power of EL emission was measured using a Newport 2835-C multi-function optical meter in conjunction with a calibrated Si photodiode. Brightness was calculated using the EL forward output power and the EL spectrum of the device, assuming Lambertian distribution of the EL emission, and verified with a Photo Research PR650 colorimeter. The lifetime of PLED devices was measured on an ELIPSE^{™} PLED Lifetime Tester (from Cambridge Display Technology) under constant current driving condition at room temperature. The driving current was set according to the current density needed to achieve the initial brightness measured using the Si photodiode. For the experiments in this disclosure, we selected 3000 nits as the initial device brightness for the blue PLED devices and 5000 nits for the green PLED devices and defined the life time of the device as the time takes for the brightness to reach 50% of the initial value. Since multiple devices were made using the same ink composition, the device performance data were reported as a range as shown in TABLE 5. These included Driving voltage (volts) and current efficiency (Cd/A) at 3000 nits (Cd/m²) brightness, and the driving voltage increase during the lifetime testing as determined by % of voltage change from initial until T₅₀. In addition, a meaure of device yield was designed to assess the consistency of the device performance derived from the specific conductive polymer ink. Device yield is the % of device numbers that showed reasonable device performance within the total number of duplicated device made within the experiment. In this regard, the term "reasonable device performance" is defined as following: current efficiency is greater than 2 Cd/A, and driving voltage is less than 10 Volts.

Viscosity of the conductive dispersion was measured using an ARES controlled-strain rheometer (TA Instruments, New Castle, DE, formerly Rheometric Scientific). Temperature was controlled at 25°C (77°F) using a circulating water bath. The atmosphere was saturated with water vapor to minimize water evaporation during testing. A Couette geometry was used; both bob and cup were constructed out of titanium. The bob was 32 mm in diameter and 33.3 mm in length; the diameter of the cup was 34 mm. Approximately 10 ml of sample was used per experiment. After sample loading, the sample was subjected to a 5 min preshear at 100 s-1 for removing the effects of loading history. After a 15 minute delay, viscosities were measured at shear rates ranging from 1 to 200 s⁻¹.

In order to characterize the film wetting property, conductive dispersions were deposited on substrates (e.g. 1" x 1" ITO/Glass supplied by Colorado Concept Coatings LLC). For the current example, spin coating method was used. The specific spin speed was selected in order to achieve the film thickness between 50-100nm. Kruss Drop Shape Analysis System model DSA100 was used to obtain the contact angle of a liquid (such as water or organic solvent) drop onto the film under study. The equipment records the drop spreading over a specified time period (60 seconds). The drop shape analysis software calculates contact angle using a circle fitting method over this 60 second period. Film surface energy was determined by using the two component Flowkes theory model. Flowkes' theory assumes that the adhesive energy between a solid and a liquid can be separated into interactions between the dispersive components of the two phases and interactions between the non-dispersive(polar) components of the two phases. The dispersive component of the surface energy σsD was determined by measuring the film contact angle with a liquid which has only a dispersive component, such Diiodomethane (σ_{L} =σ_{L}^{D} = 50.8 mN/m).. Afterwards, the film contact angle with the second liquid which has both a dispersive component and a non-dispersive (polar) component e.g. water (σ_{L}^{P} = 46.4 mN/m, σ_{L}^{D} = 26.4 mN/m) was tested. One can calculate σSP by the following equation: ( σ_{L}^{D})^{1/2}( σ_{S}^{D})^{1/2} + (σ_{L}^{P})^{1/2}(σ_{S}^{P})^{1/2} = σ_{L} (cos □+1)/2.

In a typical OLED device structure as described in Fig. 1, an electroluminescent (EL) layer could be deposited on top of the hole injection layer (HIL) by a solution method. One of the key requirement for a good device performance and film formation is a good wetting of the EL material on the HIL film substrate. It is known that wetting is the contact between a fluid and a surface. When a liquid has a high surface tension (strong internal bonds), it tends to form a droplet on the surface. Whereas a liquid with low surface tension tends to spread out over a greater area (bonding to the surface). On the other hand, if a solid surface has high surface energy (or surface tension), a drop will spread, or wet, the surface. If the solid surface has low surface energy, a droplet will form. This phenomenon is a result of the minimization of interfacial energy. The primary measurement to determine wettability is a contact angle measurement. This measures the angle between the surfaces of a liquid droplet on the solid surface. In order for wetting to take place, the surface tension of the depositing liquid must be lower than that of the surface that it is contacting. Therefore, the solid surface energy of the HIL film is an important material property. Since most of the EL materials used in OLED device use organic solvent such as xylene,or toluene as the carrying liquid, which has a liquid surface tension in the range of 18 to 30 mN/m, it is desirable that the HIL film solid surface has a surface energy of larger than 30 mN/m in order to achieve good wetting. Therefore, when a film has a solid surface energy greater than 30 mN/m, we characterize as a "wetting friendly film". Similarly, when a film has a solid surface energy less than 30 mN/m, we characterize as "None wetting friendly film".

**TABLE 5: Device fabrication from inventive dispersion A, B, C and comparative dispersion C-A1.**

| Conductive dispersion | Driving Voltage at 3000 nits (Volts) | Current Efficiency (Cd/A) | Voltage increase during LT % | Device yield |
|---|---|---|---|---|
| A | 7.2 - 7.5 | 3.7 - 5.1 | 2-10 | 100% |
| B | 8.3 - 8.4 | 2.0 - 2.3 | 2-4 | 100% |
| C | 8.2 - 8.4 | 3.1- 3.6 | 3-4 | 100% |
| C-A1 | 5.5 - 17.5 | 1.2-11.0 | >19 | 33% |

The data in TABLE 5 demonstrated that the conductive polymer dispersion comprising polyurethe polymers in this disclosure was used to make functional devices with much better consistency from device to device as comaped to the control ink (C-A1) due to much better wetting property of the conductive polymer film in terms of wetting ITO substrate and wetting of the EL solution on conductive polymer film.

While the invention has been described with reference to certain aspects or embodiments, it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiment disclosed as the best mode contemplated for carrying out this invention, but that the invention will include all embodiments falling within the scope of the appended claims.

The invention has been described in detail with particular reference to certain certain embodiments thereof, but it will be understood that variations and modifications can be effected within the spirit and scope of the invention.

## Claims

1. An aqueous dispersion comprising:
at least one electrically conductive polymer, and
at least one polyurethane polymer;
wherein the polyurethane polymer is at least partially water soluble or
water dispersible.

2. The dispersion of claim 1 wherein the electrically conductive polymer is selected from the group consisting of a polyaniline, polypyrroles, polythiophene, polyselenophenes, derivatives of polyaniline, polypyrroles, polyselenophenes, polythiophene and combinations thereof.

3. The dispersion of claim 1 wherein the electrically conductive polymer comprises at least one member selected from the group consisting of polyacetylenes, polythienothiophene/polystyrenesulfonic acid, polydioxythiophene/polystyrenesulfonic acid, polyaniline-polymeric-acid-colloids, PEDOT, PEDOT-polymeric-acid-colloids, and mixtures thereof.

4. The dispersion of claim 2, wherein the electrically conductive polymer comprises poly(thieno[3,4-b]thiophene).

5. The dispersion of any of the preceding claims comprising at least one colloid-forming polymeric acid and at least one non-fluorinated polymer acid.

6. The dispersion of any of the preceding claims, wherein the dispersion comprises a colloid-forming polymeric acid that comprises at least one fluorinated sulfonic acid polymer.

7. The dispersion of any of the preceding claims, wherein the dispersion is treated with basic ion exchange resin.

8. The dispersion of any of the preceding claims, wherein the dispersion is treated with at least one basic compound.

9. The dispersion of claim 8, wherein the basic compound comprises at least one member selected from the group consisting of sodium hydroxide, ammonium hydroxide, tetra-methylammonium hydroxide, tetra-ethylammonium hydroxide, calcium hydroxide, cesium hydroxide, and combinations thereof.

10. The dispersion of any of the preceding claims, wherein the polyurethane polymer includes at least one sulfonic acid, phosphonic acid, boronic acid, or carboxylic acid, either in the acid form or in the neutralized form, or combination thereof.

11. The dispersion of claim 1 wherein the polyurethane polymer comprises silicon and florine atoms, and/or fluorinated alkylene oxide moiety, and/or siloxane moiety, and/or polyalkylene oxide moiety.

12. The dispersion of any of the preceding claims, wherein the polyurethane polymer includes at least 5 mol% of repeat units incorporating pendent side chain sulfonic acid, phosphonic acid, boronic acid, or carboxylic acid, either in the acid form or in the neutralized form, or combination thereof, based on the total repeat units of the polyurethane.

13. An electronic device comprising:
a polyurethane polymer dispersed electrically conductive film comprising polyaniline, polypyrroles, polythiophene, polyselenophenes, derivatives of polyaniline, polypyrroles, polyselenophenes, polythiophene and combinations thereof.

14. The device of claim 13, further comprising at least one polythiophene and at least one electrically conductive electrode in contact with the electrically conductive film.

15. The device of claim 13 or 14, wherein the device comprises an organic electronic device.

16. The device of any of claims 13 to 15, wherein the device comprises at least one member selected from the group consisting of organic light emitting diodes, organic optoelectronic devices, organic photovoltaic devices, diodes, and transistors.

17. A method for producing an aqueous dispersion comprising at least one conductive polymer, and at least one polyurethane polymer, comprises the following:
(a) providing an aqueous solution comprising one or more of an oxidant and a catalyst;
(b) providing an aqueous dispersion comprising an effective amount of the polyurethane polymer;
(c) combining the aqueous solution of the oxidant and/or catalyst with the aqueous dispersion of the polyurethane polymer ;
(d) adding a monomer or a precursor of the conductive polymer to the combined aqueous dispersion of step (c) ;
(e) polymerizating the monomer or precursor containing polyurethane dispersion to form a polymeric dispersion; and
(f) contacting the polymeric dispersions with ion exchange resin(s) to remove impurities.

18. A method for producing an aqueous dispersion comprising at least one conductive polymer, and at least one polyurethane polymer, comprises the following:
(a) providing an aqueous solution comprising at least one oxidant and/or
at least one catalyst;
(b) providing an aqueous dispersion comprising an effective amount of the polyurethane polymer;
(c) adding the aqueous dispersion of polyurethane polymer of step (b) to a monomer or a precursor of the conductive polymer;
(d) adding the oxidant and/or catalyst solution of step (a) to the combined mixture of step (c);
(e) polymerizating the monomer or precursor containing polyurethane dispersion to form a condutive polymeric dispersion; and
(f) contacting the polymeric dispersions with ion exchange resin(s) to remove impurities

19. The method of claim 17 or 18, further comprising adjusting the pH of the polymer dispersion using ion exchange resin or a basic solution.
